(19) Europäisches Patentamt
European Patent Office
Office européen des brevets

(11) **EP 2 819 497 B1**

## (12) EUROPEAN PATENT SPECIFICATION

(45) Date of publication and mention
of the grant of the patent:
**11.07.2018 Bulletin 2018/28**

(21) Application number: **12869566.5**

(22) Date of filing: **21.02.2012**

(51) Int Cl.:
**H05K 13/04** *(2006.01)*     **H05K 13/02** *(2006.01)*

(86) International application number:
**PCT/JP2012/054140**

(87) International publication number:
**WO 2013/124970 (29.08.2013 Gazette 2013/35)**

(54) **SUBSTRATE CONVEYING DEVICE**

SUBSTRATFÖRDERVORRICHTUNG

DISPOSITIF DE TRANSPORT DE SUBSTRAT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**31.12.2014 Bulletin 2015/01**

(73) Proprietor: **Fuji Machine Mfg. Co., Ltd.**
**Chiryu-shi**
**Aichi 472-8686 (JP)**

(72) Inventors:
• **SHIMIZU, Toshinori**
**Chiryu-shi**
**Aichi 472-8686 (JP)**

• **MAEDA, Fumitaka**
**Chiryu-shi**
**Aichi 472-8686 (JP)**

(74) Representative: **Grünecker Patent- und**
**Rechtsanwälte**
**PartG mbB**
**Leopoldstraße 4**
**80802 München (DE)**

(56) References cited:
**JP-A- 2001 274 594     JP-A- 2006 229 095
JP-A- 2009 043 954     JP-A- 2009 054 620
US-A1- 2005 080 508     US-A1- 2007 277 369
US-B1- 6 354 430**

## Description

Technical Field

The present invention relates to a substrate conveying device according to claim 1, similar to what is known from PTL 3, and, in particular, to operation stop control which is performed on a belt conveyor included in the substrate conveying device. Similar devices are known from PTL 4 and PTL 5.

Background Art

PTL 1 below discloses a substrate conveying device which operates a belt conveyor by a set operation amount and stops the belt conveyor from a time point at which the downstream side end of a circuit substrate in a conveyance direction is detected by a substrate sensor. In addition, PTL 2 discloses a substrate conveying device which stops the operation of a belt conveyor according to detection of the downstream side end of a circuit substrate by a substrate sensor.

Citation List

Patent Literature

PTL 1: JP-A-2004-228326
PTL 2: JP-A-8-316697
PTL 3: US 2005/080508 A1
PTL 4: US 6 354 430 B1
PTL 5: US 2007/277369 A1.

Summary of Invention

Technical Problem

The present invention is made in consideration of the above circumstances, and the present invention aims to improve the practical use of a control for stopping operation of a belt conveyor of a substrate conveying device.

Solution to Problem

The aim is achieved by providing a substrate conveying device according to claim 1. An exemplary substrate conveying device disclosed herein includes: (a) a belt conveyor that supports a circuit substrate using a conveyor belt from a lower side and conveys the circuit substrate in a conveyance direction; (b) an upstream side substrate sensor and a downstream side substrate sensor that are respectively provided at two separate places of the belt conveyor in the conveyance direction, and output different signals depending on whether the circuit substrate is detected or is not detected; (c) a first operation control unit that operates the belt conveyor by a set operation amount and stops the belt conveyor after a moment in which the upstream side substrate sensor detects an upstream side end or a downstream side end of the circuit substrate in the conveyance direction; (d) a second operation control unit that stops the operation of the belt conveyor according to detection of the downstream side end of the circuit substrate performed by the downstream side substrate sensor; and (e) an operation control selection unit that is capable of selecting the first operation control unit or the second operation control unit.

Advantageous Effects of Invention

When the first operation control unit or the second operation control unit is selected, it is possible to selectively stop the circuit substrate at a position where the circuit substrate is moved by a distance determined based on the set operation amount after the upstream side end or the downstream end is detected, or at a position where the downstream side end is detected by the downstream side substrate sensor, and thus an easy-to-use substrate conveying device can be provided. Further, as it is possible to switch the operation stop control performed on the belt conveyor in such a way that the operation control selection unit selects the first operation control unit or the second operation control unit, it is not necessary to change or set up components, and thus it is easy to perform switching.

Aspects of Invention

(1) A substrate conveying device comprising: a belt conveyor that is configured to support a circuit substrate using a conveyor belt from a lower side and to convey the circuit substrate in a conveyance direction; an upstream side substrate sensor and a downstream side substrate sensor that are respectively provided at two separated places of the belt conveyor in the conveyance direction, and are configured to out-put different signals depending on whether the circuit substrate is detected or is not detected; a first operation control unit that is configured to operate the belt conveyor by a set operation amount and to stop the belt conveyor, after a moment in which the upstream side substrate sensor detects an upstream side end or a downstream side end of the circuit substrate in the conveyance direction; a second operation control unit that is configured to stop the operation of the belt conveyor according to detection of the downstream side end of the circuit substrate performed by the downstream side substrate sensor; and an operation control selection unit that is capable of selecting the first operation control unit or the second operation control unit.

The substrate conveying device is used, for example, to convey a substrate in a circuit substrate working machine, such as an electronic circuit component mounting machine, a screen printing machine, a glue dispenser, and a substrate inspection machine.

It is possible for the first operation control unit to operate the belt conveyor by the set operation amount and stop the belt conveyor on and after the moment in which the upstream side substrate sensor detects the upstream side end of the circuit substrate in the conveyance direction and to operate the belt conveyor by the set operation amount and stop the belt conveyor on and after the moment in which the upstream side substrate sensor detects the downstream side end of the circuit substrate in the conveyance direction. The former is preferable because the set operation amount of the belt conveyor is small and it is possible to cause a circuit substrate stop position accuracy to be high by the first operation control unit.

(2) In the substrate conveying device of (1), the first operation control unit is configured to operate the belt conveyor by the set operation amount and to stop the belt conveyor, after the moment in which the upstream side substrate sensor detects the upstream side end of the circuit substrate in the conveyance direction, and the substrate conveying device further comprises: an actual operation amount detection unit that is configured to detect an actual operation amount of the belt conveyor from a moment in which the downstream side end of the circuit substrate is detected by the downstream side substrate sensor while the belt conveyor is being operated by the first operation control unit; and a correction operation unit that is configured to operate the belt conveyer again and stops the belt conveyor, after the first operation control unit stops the operation of the belt conveyor, in order to reduce a difference between the actual operation amount, which is detected by the actual operation amount detection unit, and a logical operation amount, which is determined based on (a) the set operation amount, (b) a substrate length which is a distance between the upstream side end and the downstream side end of the circuit substrate in the conveyance direction, and (c) a distance between the upstream side substrate sensor and the downstream side substrate sensor in the conveyance direction.

When the circuit substrate is conveyed by the belt conveyor, there are cases in which relative displacement is generated between the circuit substrate and the conveyor belt due to the vibration of the circuit substrate and the conveyor belt, the frictional resistance of a guide member with regard to the circuit substrate, the inertial force of the circuit substrate when acceleration and deceleration are performed, and the like, and in which the actual stop position of the circuit substrate is deviated from a logical stop position which is determined based on the set operation amount. In a case of the second operation control unit, it is possible to stop the circuit substrate in a position which is set in advance with an excellent accuracy at which the downstream side end is detected by the downstream side substrate sensor, even when the relative displacement is generated between the circuit substrate and the conveyor belt. In contrast, in a case of the first operation control unit, the belt conveyor is operated by the set operation amount and is stopped regardless of the detection of the downstream side end of the circuit substrate performed by the downstream side substrate sensor. Therefore, deviation may occur in a circuit substrate stop position. However, it is possible to improve the circuit substrate stop position accuracy by detecting the actual operation amount, estimating stop position errors, and correcting the errors. This is the same as in a substrate conveying device which will be described in a subsequent clause.

Accordingly, for example, when the substrate conveying device is provided in the circuit substrate working machine and the circuit substrate is supported by a substrate support device from a back surface, it is possible to avoid interference between a substrate support member and electronic circuit components which are mounted on the back surface. Further, when a reference mark which is provided in the circuit substrate is imaged by an imaging device, deviation with regard to the reference mark of the imaging device is reduced, and thus reference mark detection accuracy and a detection speed are improved. Further, it is not necessary to convey the circuit substrate again due to the reference mark being out of sight of the imaging device, and thus deterioration in the detection efficiency of the reference mark is avoided.

(3) In the substrate conveying device of (1), the first operation control unit is configured to operate the belt conveyor by the set operation amount and stop the belt conveyor, after the moment in which the upstream side substrate sensor detects the downstream side end of the circuit substrate in the conveyance direction, and the substrate conveying device further comprises: an actual operation amount detection unit that is configured to detect an actual operation amount of the belt conveyor from a moment in which the downstream side end of the circuit substrate is detected by the downstream side substrate sensor while the belt conveyor is being operated by the first operation control unit; and a correction operation unit that is configured to operate the belt conveyor again and stops the belt conveyor, after the first operation control unit stops the operation of the belt conveyor, in order to reduce a difference between the actual operation amount, which is detected by the actual operation amount detection unit, and a logical operation amount, which is determined based on (a) the set operation amount and (b) a distance between the upstream side substrate sensor and the downstream side substrate sensor in the conveyance direction.

(4) The substrate conveying device of (2) or (3), further comprising: a determination unit for determining operations/non operations regarding a required stop position accuracy that is configured to determine operations of the actual operation amount detection unit and the correction operation unit when the circuit substrate, which is conveyed by the belt conveyor, requires a higher stop position accuracy than a set accuracy, and that is configured to determine non-operations of the actual operation amount detection unit and the correction operation unit when the circuit substrate does not require the higher stop position accuracy than the set accuracy under a condition in which the first operation control unit is selected by the operation control selection unit.

The set accuracy is set based on deviation which is permitted when work or access with regard to the circuit substrate is performed. The work with regard to the circuit substrate includes, for example, mounting of the electronic circuit components, application of a creamy solder, and the like, and the access includes, for example, the support of the circuit substrate by the substrate support device. When the stop position of the circuit substrate does not need to be corrected, it is possible to reduce a time required for conveying the circuit substrate because the correction is not performed.

(5) The substrate conveying device of any one of (1) to (4), further comprising: a circuit substrate length responsive selection unit in which the operation control selection unit is configured to select the first operation control unit when the substrate length, which is the distance between the upstream side end and the downstream side end of the circuit substrate in the conveyance direction, is longer than a set length, and is configured to select the second operation control unit when the substrate length is equal to or less than the set length.

It is possible to deal with a case where the control performed by at least any one of the first and second operation control units is limited by the substrate length.

(6) In the substrate conveying device of (5), the downstream side substrate sensor is installed in a position corresponding to a middle point between the upstream side end and the downstream side end of the circuit substrate in the conveyance direction in a position where a circuit substrate which has a substrate length longer than the set length is to be stopped, and the set operation amount is set so that the middle point comes into a position corresponding to the downstream side substrate sensor.

It is possible to stop the circuit substrate in a position which is symmetrical with the downstream side substrate sensor in the conveyance direction. Accordingly, for example, when the circuit substrate is conveyed in both the forward and reverse direction by the substrate conveying device, the downstream side substrate sensor for forward direction conveyance is also used as the downstream side substrate sensor for the reverse direction conveyance. Regardless of a direction in which conveyance is performed, it is possible to stop the circuit substrate in the same position with regard to the downstream side substrate sensor in the conveyance direction. Therefore when the substrate conveying device is provided in the circuit substrate working machine, the movement range of a work head is commonly used, and thus it is possible to avoid the enlargement of the working machine. If a position where the circuit substrate should be stopped is set so that the middle point thereof is located at the middle point of the belt conveyor, the set operation amount is the same in cases of conveyance in the forward direction and conveyance in the reverse direction, and thus it is possible to control the belt conveyor in the same manner. Further, it is possible to reduce the circuit substrate working machine in size by narrowing the movable range of the work head in the circuit substrate working machine, or it is possible to improve work efficiency by shortening the total movement distance of the work head.

Brief Description of Drawings

[Fig. 1] Fig. 1 is a plan view illustrating an electronic circuit component mounting machine which includes a substrate conveying device according to an embodiment of a claimable invention.
[Fig. 2] Fig. 2 is a back view (partial cross section) illustrating the substrate conveying device.
[Fig. 3] Fig. 3 is a block diagram conceptually illustrating the configuration of the control device of the electronic circuit component mounting machine.
[Fig. 4] Fig. 4 is a flowchart illustrating a main conveyor operation control selection routine which is stored in the ROM of a computer which is a principal component of the control device.
[Fig. 5] Fig. 5 is a flowchart illustrating a substrate carry-in routine which is stored in the ROM of the computer.
[Fig. 6] Fig. 6 is a view illustrating the conveyance and stop of a circuit substrate when the main conveyor is controlled through second operation control.
[Fig. 7] Fig. 7 is a flowchart illustrating a second operation control routine which is stored in the ROM of the computer.

[Fig. 8] Fig. 8 is a view illustrating the output of a drive pulse of an electric motor for accelerating and decelerating the main conveyor.

[Fig. 9] Fig. 9 is a view illustrating the conveyance and stop of the circuit substrate when the main conveyor is controlled through first operation control without correction.

[Fig. 10] Fig. 10 is a view illustrating the conveyance and stop of another circuit substrate when the main conveyor is controlled through the first operation control without correction.

[Fig. 11] Fig. 11 is a flowchart illustrating the first operation control routine without correction which is stored in the ROM of the computer.

[Fig. 12] Fig. 12 is a view illustrating the conveyance and stop of the circuit substrate, and correction of stop position errors when the main conveyor is controlled by first operation control with correction for a particularly long substrate.

[Fig. 13] Fig. 13 is a flowchart illustrating a first operation control routine with correction for the particularly long substrate, which is stored in the ROM of the computer.

[Fig. 14] Fig. 14 is a view illustrating the conveyance and stop of the circuit substrate, and the correction of the stop position errors when the main conveyor is controlled by first operation control with correction for the long substrate.

[Fig. 15] Fig. 15 is a flowchart illustrating the first operation control routine with correction for the long substrate, which is stored in the ROM of the computer.

[Fig. 16] Fig. 16 is a view illustrating the conveyance and stop of the circuit substrate when the main conveyor is controlled by the first operation control without correction according to another embodiment.

[Fig. 17] Fig. 17 is a flowchart illustrating the first operation control routine without correction for executing the first operation control without correction shown in Fig. 16.

[Fig. 18] Fig. 18 is a view illustrating the conveyance and stop of the circuit substrate, and the correction of the stop position errors when the main conveyor is controlled by first operation control with correction according to another embodiment.

[Fig. 19] Fig. 19 is a flowchart illustrating the first operation control routine with correction for executing the first operation control with correction shown in Fig. 18.

Description of Embodiments

Hereinafter, some embodiments of the claimable invention will be described with reference to the accompanying drawings. Meanwhile, the claimable invention can be implemented with an aspect in which various changes are performed based on the knowledge of those skilled in the art from the aspects which are described in the above [Aspects of Invention] in addition to embodiments below.

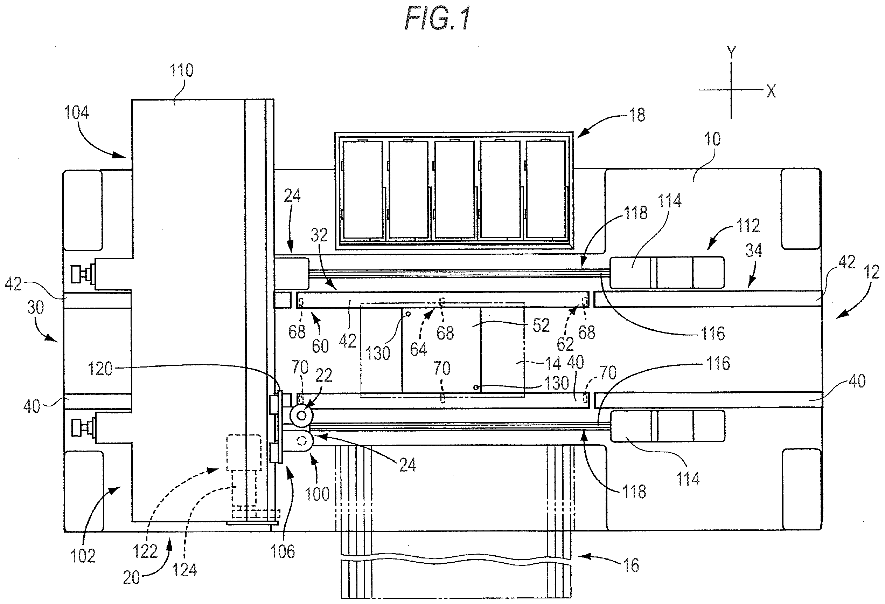

An electronic circuit component mounting machine according to an embodiment includes a bed 10 which is a main body of a mounting machine, a substrate conveyor group 12, a substrate holding device 14, component supply devices 16 and 18, a mounting device 20 which is a work device, a reference mark imaging device 22, a component imaging device 24 and a control device 26, as shown in Fig. 1.

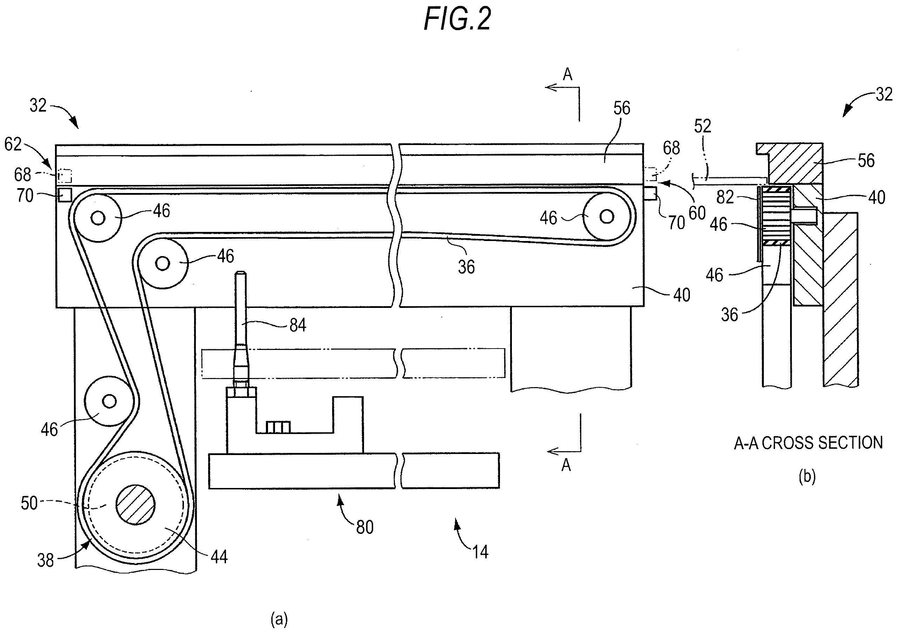

In the embodiment, the substrate conveyor group 12 includes a conveyor 30 for carrying in or out a substrate, a main conveyor 32, and a conveyor 34 for carrying in or out the substrate. All of the conveyors 30, 32, and 34 are belt conveyors, and each of the conveyors includes a pair of endless conveyor belts 36 and a belt orbiting device 38. The belt orbiting device 38 includes drive pulleys 44 which are rotatably attached to the respective opposite inner side surfaces of side frames 40 and 42 (the side frame 40 on the one side of the main conveyor 32 is illustrated in Fig. 2), a plurality of guide pulleys 46, and an electric motor 50 which is common to each of the drive pulleys 44 of the side frames 40 and 42.

The pulleys 44 and 46 are timing pulleys, the conveyor belts 36 are timing belts, the pair of conveyor belts 36 are orbited by the belt orbiting device 38 at the same time, and a circuit substrate 52 (hereinafter, abbreviated to the substrate 52), in which both side end portions which are parallel to each other are supported by the conveyor belts 36 from a lower side, is conveyed in a horizontal position while being guided on both sides in the width direction by guide rails 56 which are guide members. The width direction is a direction perpendicular to the conveyance direction in a horizontal plane which is a plane parallel to the mounted surface which is the worked surface of the substrate 52. In the embodiment, it is assumed that the conveyance direction of the substrate 52 is an X-axis direction and the width direction is a Y-axis direction. The electric motor 50 is a pulse motor in the embodiment.

In the embodiment, the main conveyor 32 is included in the substrate conveying device according to the embodiment of the claimable invention. As shown in Fig. 1, a substrate sensor 60 is provided at the upstream end of the main conveyor 32 in the conveyance direction, a substrate sensor 62 is provided at the downstream end, and a substrate sensor 64 is provided between the substrate sensors 60 and 62. In the embodiment, the substrate sensor 64 is provided in a central position of the main conveyor 32 in the conveyance direction.

In the embodiment, the sensors 60, 62, and 64 are formed of a transmission-type photoelectric sensor which is a contactless sensor-type photoelectric sensor. The sensors 60, 62, and 64 include light emitting units 68 and light receiving units 70 which are provided to face each other while being apart from each other in the width direction, output an ON signal in a state in which the light receiving units 70 receive light, and output an OFF signal when the light receiving units 70 do not receive light, as shown in Fig. 1.

The substrate holding device 14 is provided at the central part of the main conveyor 32 in the conveyance direction as shown in Fig. 1, includes a substrate support device 80 and a clamp member 82 as shown in Figs. 2(a) and 2(b), and holds the substrate 52 with a horizontal posture. The substrate support device 80 supports the back surface of the substrate 52, which is a supported surface, from a lower side using a support pin 84 which is a support member.

The mounting device 20 includes the mounting head 100 which is the work head and a head movement device 102 as shown in Fig. 1. The head movement device 102 includes an X-axis direction movement device 104 and a Y-axis direction movement device 106, and moves the mounting head 100 to an arbitrary location in a horizontal surface. The X-axis direction movement device 104 includes an X-axis slide 110 as a movable member and an X-axis slide movement device 112. The X-axis slide movement device 112 includes an electric motor 114, a ball screw 116 which is a feed screw, and a feed screw mechanism 118 which has a nut (not shown in the drawing). In the embodiment, the Y-axis direction movement device 106 is provided in the X-axis slide 110, and includes a Y-axis slide 120 as a movable member, and a Y-axis slide movement device 122. The Y-axis slide movement device 122 includes an electric motor 124 and a feed screw mechanism (not shown in the drawing). The electric motors 114 and 124 are formed of a servo motor with an encoder or a pulse motor. The mounting head 100 holds an electronic circuit component using an adsorption nozzle which is a component holding tool, and is mounted on the Y-axis slide 120.

The reference mark imaging device 22 is mounted on the Y-axis slide 120, is moved to an arbitrary position in the horizontal surface using the head movement device 102, and images a reference mark 130 which is provided on the mounted surface of the substrate 52. The imaging devices 22 and 24 include, for example, a CCD camera or a CMOS camera which is one kind of imaging machine.

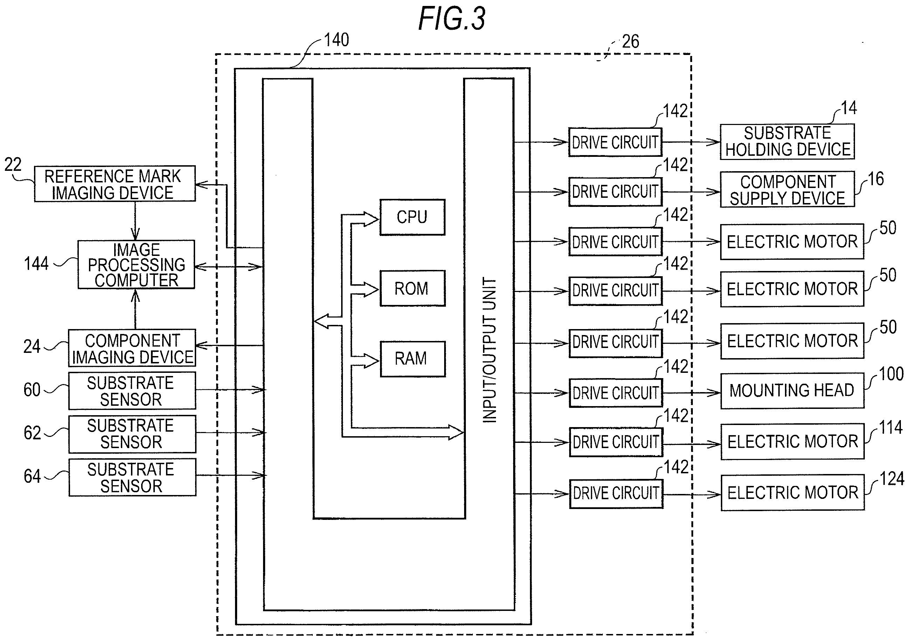

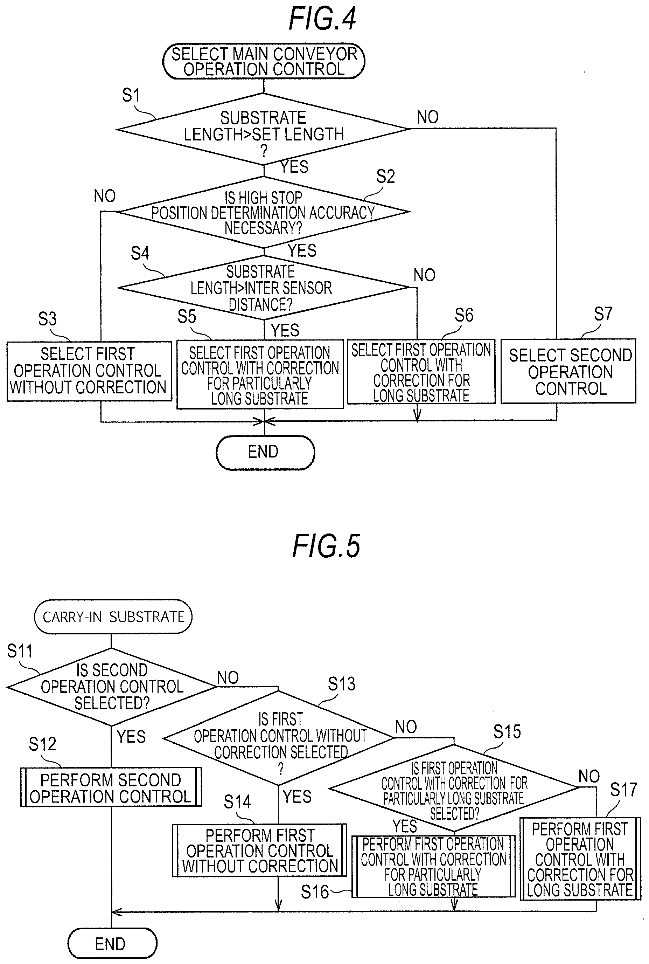

As shown in Fig. 3, the control device 26 includes a mounting control computer 140 as a principal component, and controls driving sources, such as the respective electric motors 50 of the conveyors 30, 32, and 34, of various devices of the electronic circuit component mounting machine through drive circuits 142. Data, which are obtained through imaging performed by the imaging devices 22 and 24, are processed by an image processing computer 144, and data obtained through the process are supplied to the mounting control computer 140. Further, a program or the like, shown in a flowchart in Fig. 4 or the like, is stored in the ROM of the mounting control computer 140.

Conveyance of the substrate 52 performed by the main conveyor 32 will be described. The conveyors 30, 32, and 34 can convey the substrate 52 in both the forward and reverse directions by changing the orbiting direction of the conveyor belts 36. Here, an example of a case in which the substrate 52 is conveyed from the left to the right in Fig. 1 will be described. In this case, the conveyor 30 functions as a carry-in conveyor, the conveyor 34 functions as an carry-out conveyor, the substrate sensor 60 functions as an upstream side substrate sensor, and the substrate sensor 64 functions as a downstream side substrate sensor. Further, the substrate sensor 62 detects the carry-out of the substrate 52 from the main conveyor 32 to the carry-out conveyor 34. Hereinafter, the substrate sensor 60 is called an upstream side substrate sensor 60, and the substrate sensor 64 is called a downstream side substrate sensor 64. When the substrate 52 is conveyed in the reverse direction, the conveyor 34 functions as the carry-in conveyor, the conveyor 30 functions as the carry-out conveyor, and the substrate sensor 62 functions as the upstream side substrate sensor, respectively.

Before the mounting of a series of electronic circuit components on the substrate 52 starts, a main conveyor operation control selection routine shown in Fig. 4 is executed. First, in step 1 (hereinafter, abbreviated to S1. It is the same as for other steps), it is determined whether or not a substrate length, which is a distance between the upstream side end and the downstream side end of the substrate 52 in the conveyance direction, is longer than a set length. The substrate length is obtained based on the kind of the substrate 52. A method of determining the set length will be described later.

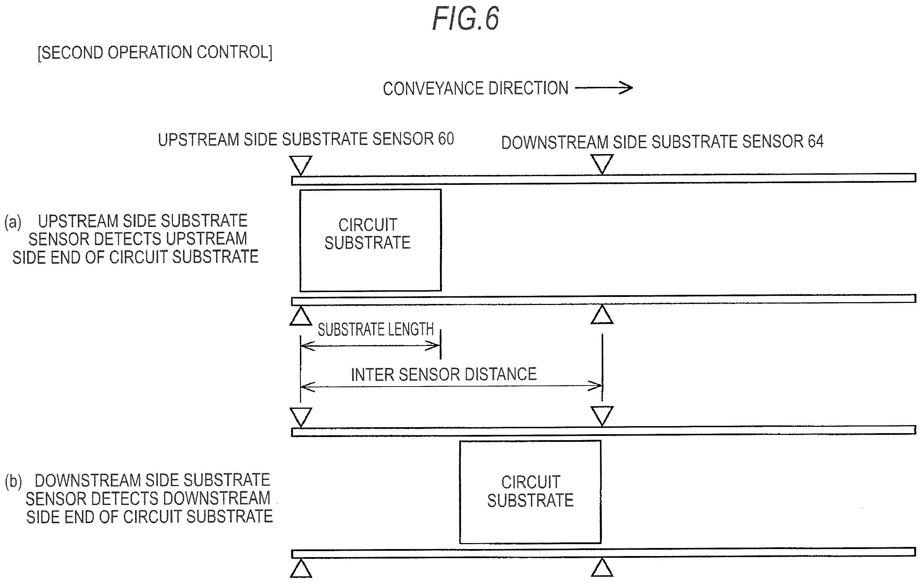

If the substrate length is equal to or less than the set length, NO is determined in S1. In addition, when the substrate 52 is carried in, second operation control is selected as control, which is performed on the main conveyor 32 and is stored in an operation control selection memory which is provided in the RAM of the mounting control computer 140 in S7. As shown in Fig. 6(b), the second operation control is control for stopping an operation of the main conveyor 32 if the downstream side end of the substrate 52 (hereinafter, abbreviated to a substrate downstream side end) in the conveyance direction is detected by the downstream side substrate sensor 64. The operation control selection memory forms a storage section. It is the same as for other memories which will be described below.

When the substrate length is longer than the set length, YES is determined in S1, and it is determined whether or not the substrate 52 requires high stop position accuracy in S2. For example, when a large number of electronic circuit components have been mounted on the back surface of the substrate 52, errors in the stop position of the substrate and the consequently deviated substrate with regard to the substrate support device 80 may cause interference with the support pin 84, therefore the high stop position accuracy is required. For each kind of the substrate 52, a stop position error which is permitted is set based on whether or not the electronic circuit components are mounted on the back surface of the substrate 52, the number of mounted electronic circuit components, and the mounting positions and the like. If the permitted stop position error is equal to or less than a set value, it is assumed that the high stop position accuracy is required. The set value is set accuracy. Whether or not the substrate 52 requires the high stop position accuracy is set in advance according to the kind of the substrate 52, and stored in the substrate stop position accuracy set memory which is provided in the RAM.

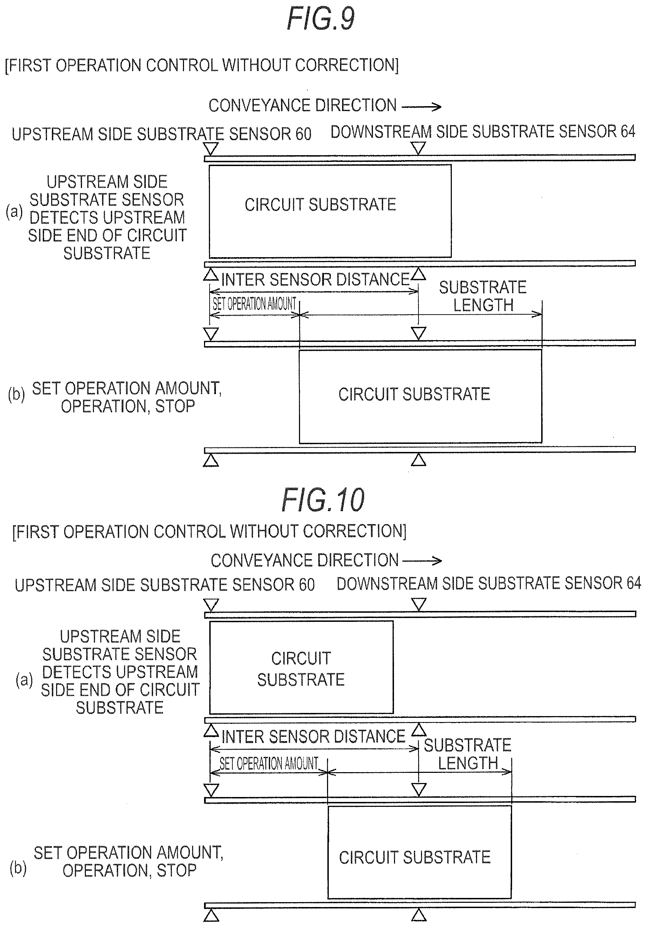

If the substrate 52 does not require the high stop position accuracy, NO is determined in S2, a process in S3 is performed, and first operation control without correction is selected and stored in the operation control selection memory. As shown in Figs. 9 and 10, the first operation control is control for operating the main conveyor 32 by set operation amount and stopping the main conveyor 32 after detecting the substrate upstream side end using the upstream side substrate sensor 60. Further, the first operation control without correction is control in which the stop position error of the substrate 52 is not corrected. In the embodiment, as shown in Figs. 9(b) and 10(b), a position, where the middle point of the substrate 52 in the conveyance direction is positioned at the middle point of the main conveyor 32 in the conveyance direction, is a position where the substrate 52 which has a substrate length longer than the set length should be stopped. The downstream side substrate sensor 64 is provided in a central position of the main conveyor 32 in the conveyance direction and is installed in a position corresponding to the middle point of the substrate 52. In the first operation control, the set operation amount is set so that the middle point of the substrate 52 comes into a position corresponding to the downstream side substrate sensor 64 regardless of whether or not correction is performed.

If the substrate 52 requires the high stop position accuracy, YES is determined in S2, with the result that a process in S4 is performed, and thus it is determined whether or not the substrate length is longer than a distance between the upstream side substrate sensor 60 and the downstream side substrate sensor 64 in the conveyance direction (hereinafter, abbreviated to an inter sensor distance). The inter sensor distance is set in advance. If the substrate length is longer than the inter sensor distance (the substrate 52 is called "particularly long substrate" in a sense of especially long substrate from among "long substrates"), YES is determined in S4, with the result that a process in S5 is performed, and thus the first operation control with correction for the particularly long substrate is selected and stored in the operation control selection memory. If the substrate length is longer than the set length and is equal to or less than the inter sensor distance, NO is determined in S4, and thus the first operation control with correction for the long substrate which is for a normal long substrate is selected in S6 and stored in the operation control selection memory. As will be described later, in the first operation control with correction, the actual operation amount of the main conveyor 32 is obtained based on the detection of the substrate downstream side end performed by the downstream side substrate sensor 64 and the stop position error of the substrate 52 is calculated. However, since the order of detection of the substrate end performed by the substrate sensors 60 and 64 is reversed according to whether or not the substrate length is longer than the inter sensor distance, two kinds of first operation control routine with correction are prepared, and selected according to the substrate length.

Whenever a piece of substrate 52 is carried into the main conveyor 32, the substrate carry-in routine shown in Fig. 5 is performed. In the routine, determinations performed in S11, S13, and S15 are performed based on the operation control stored in the operation control selection memory, and the main conveyor 32 is operated according to the selected operation control (S12, S14, S16, and S17).

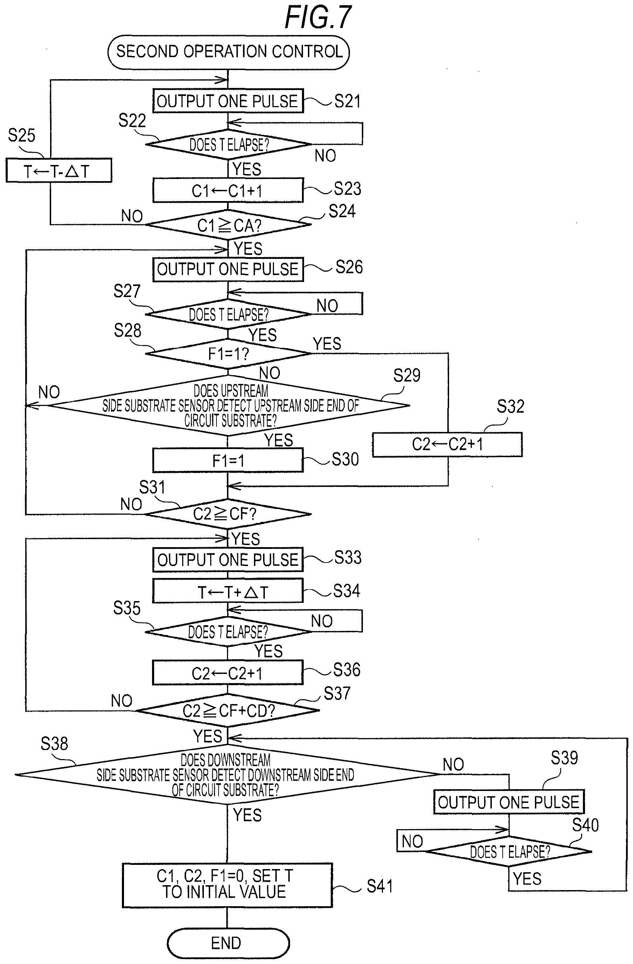

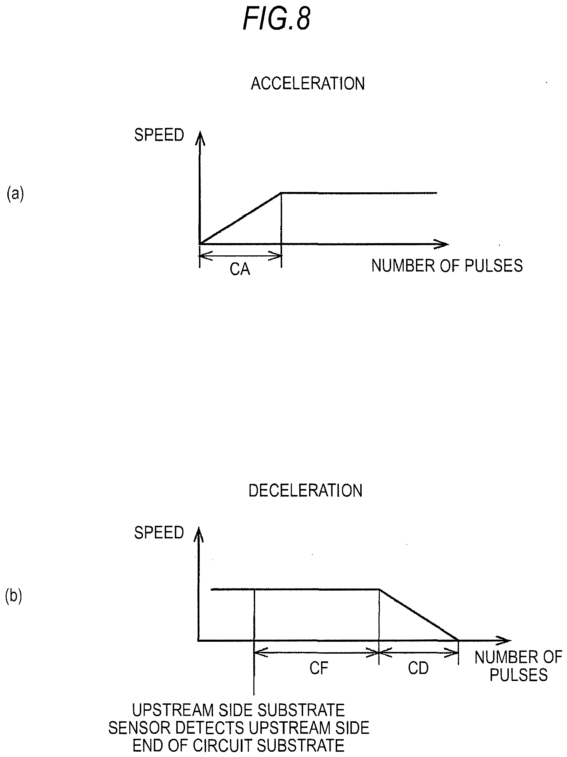

If the second operation control is selected, the main conveyor 32 is operated by performing the second operation control routine shown in Fig. 7. When the substrate 52 is conveyed, the electric motor 50 is controlled using a speed control pattern which includes acceleration, a constant speed, and deceleration. A single drive pulse of the electric motor 50 is output whenever a set time T elapses and a pulse width is regular (S21, S22). However, in a case of acceleration, the set time T becomes short by $\Delta T$ whenever one pulse is output, and thus a substrate convey speed is increased (S25). The number of output pulses is counted with the increase in a count value C1 of a first counter (S23), the processes in S21 to S25 are repeatedly performed until the count value C1 reaches a set number CA (S24), and thus the substrate convey speed is increased. As shown in Fig. 8(a), the set number CA is the number of output pulses, which are required until the substrate convey speed reaches a constant speed traveling speed, and is set in advance.

If the number of output pulses reaches the set number CA, thereafter, a pulse is output whenever the set time T elapses at the time point, the substrate 52 is conveyed at the constant speed (S26, S27), and the processes in S26 to S29 are repeatedly performed until the substrate upstream side end is detected by the upstream side substrate sensor 60. A state is changed from a state, in which the substrate 52 obstructs the light reception of the light receiving units 68 of the upstream side substrate sensor 60 and the upstream side substrate sensor 60 outputs an OFF signal, to a state in which the substrate 52 is left from the upstream side substrate sensor 60 and an ON signal is output as shown in Fig. 6(a). If the upstream side end of the substrate 52 is detected, a flag F1 is set to 1 (S30). Therefore, the detection is stored, and, thereafter, YES is determined in 28 and processes in S29 and S30 are bypassed. In addition, a count value C2 of a second counter is increased by 1 whenever a pulse is output (S32), and the number of output pulses is counted after the substrate upstream side end is detected.

The operation of the main conveyor 32 is decelerated and stopped, and the number of pulses CD and a deceleration incline, which are necessary for deceleration and shown in Fig. 8(b), are set in advance. In addition, deceleration is performed after the upstream side end of the substrate 52 is detected by the upstream side substrate sensor 60 and the constant speed control corresponding to the set amount is performed. The number of pulses CF corresponding to the set amount is set in advance for each kind of the substrate 52 based on the number of pulses CD, the inter sensor distance, and the substrate length, and the numbers of pulses CF and CD are counted by the second counter. Until the count value C2 reaches the set number CF, processes in S26 to S28, S32, and S31 are repeatedly performed. If the count value C2 reaches the set number CF, thereafter, the set time T becomes long by $\Delta T$ (S33 and S34) whenever one pulse is output, and the substrate convey speed is reduced. In addition, the number of output pulses is counted by the second counter (S36), and processes in S33 to S37 are repeatedly performed until the count value C2 is equal to or greater than the sum of the set numbers CF and CD.

Therefore, after the main conveyor 32 is decelerated down to a predetermined low speed and the YES is determined in S37, processes in S38, S39, and S40 are repeatedly performed, and it is waited that the substrate downstream side end is detected by the downstream side substrate sensor 64. The number of pulses CF is set such that the substrate downstream side end is not detected by the downstream side substrate sensor 64 before the main conveyor 32 is decelerated to the low speed, that is, before the number of pulses generated after the substrate upstream side end is detected by the upstream side substrate sensor 60 reaches the sum of the set numbers CF and CD and, further, such that the operation of the main conveyor 32 is not uselessly performed long due to the low speed. Therefore, after the main conveyor 32 reaches the predetermined low speed, YES is determined in S38 in a relatively short time, a process in S41 is performed, and thus the output of a pulse is terminated. Therefore, the operation of the main conveyor 32 stops and the substrate 52 stops. In S41, the count values C1 and C2 are cleared to 0, the flag F1 is reset to 0, the set time T is returned to an initial value, and thus the execution of the routine is terminated.

After the substrate 52 is decelerated down to the predetermined low speed, the substrate 52 stops in the position shown in Fig. 6(b) in the above-described second operation control. However, it is necessary to satisfy both conditions that (1) the main conveyor 32 can be decelerated down to a predetermined low speed before the stop position (more specifically, a set length which will be described below is equal to or less than a value obtained by subtracting a movement distance which is necessary for the deceleration control of the main conveyor 32 from the inter sensor distance), and that (2) the electronic circuit component mounting machine can perform a predetermined component mounting work on the stopped substrate 52. Therefore, the set length which is used in S1 of the above-described main conveyor operation control selection routine should be set such that the two conditions are satisfied.

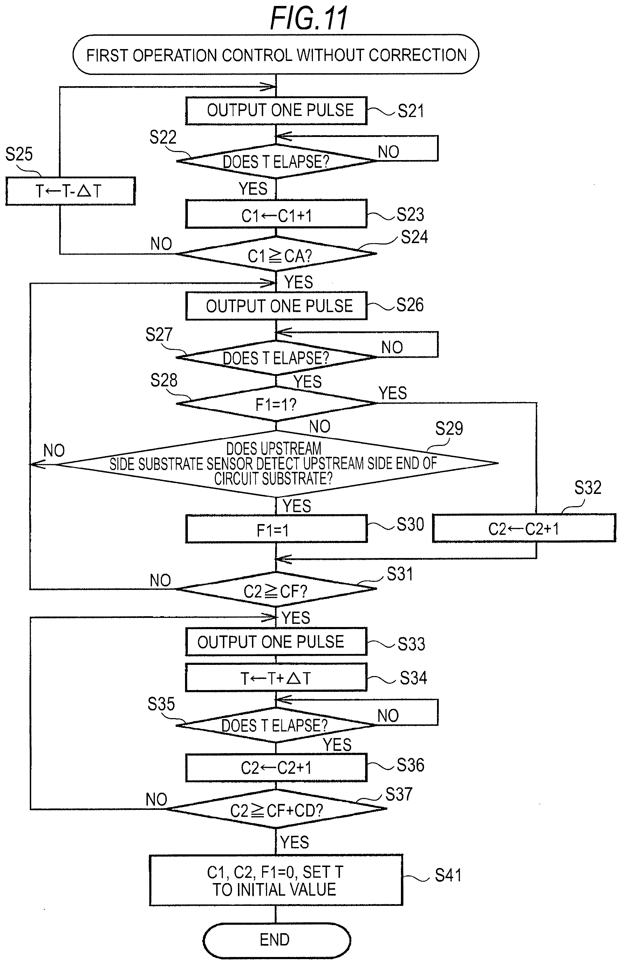

If the first operation control without correction is selected, a routine shown in Fig. 11 is performed. In the first operation control without correction, after the substrate upstream side end is detected by the upstream side substrate sensor 60, the pulse of the set number CF is output for the constant speed control, the pulse of the set number CD is output for the deceleration control, the constant speed control is performed on the main conveyor 32, and then the main conveyor 32 is decelerated down to the predetermined low speed and stops. The set number CD is common to substrates 52 of different kinds and is the same as the set number CD for the deceleration control in the second operation control. The set number CF is obtained by subtracting the set number CD from the number of pulses, which defines the set operation amount, and is set so that the operation amount of the main conveyor 32 exactly becomes the set operation amount and the operation stops in a state where the deceleration control is performed as many as the number of pulses CD. As shown in Figs. 9 and 10, the set operation amount is set based on the inter sensor distance and the substrate length, and the set number CF is set for each kind of the substrate 52.

As above, in the first operation control without correction, the downstream side substrate sensor 64 is not used, and the first operation control routine without correction is configured such that S38 to S40 are excluded from the second operation control routine shown in Fig. 7. In addition, regardless of whether the substrate length is longer or shorter than the inter sensor distance as shown in Figs. 9 and 10, the operation of the main conveyor 32 is controlled by performing the first operation control routine without correction shown in Fig. 11.

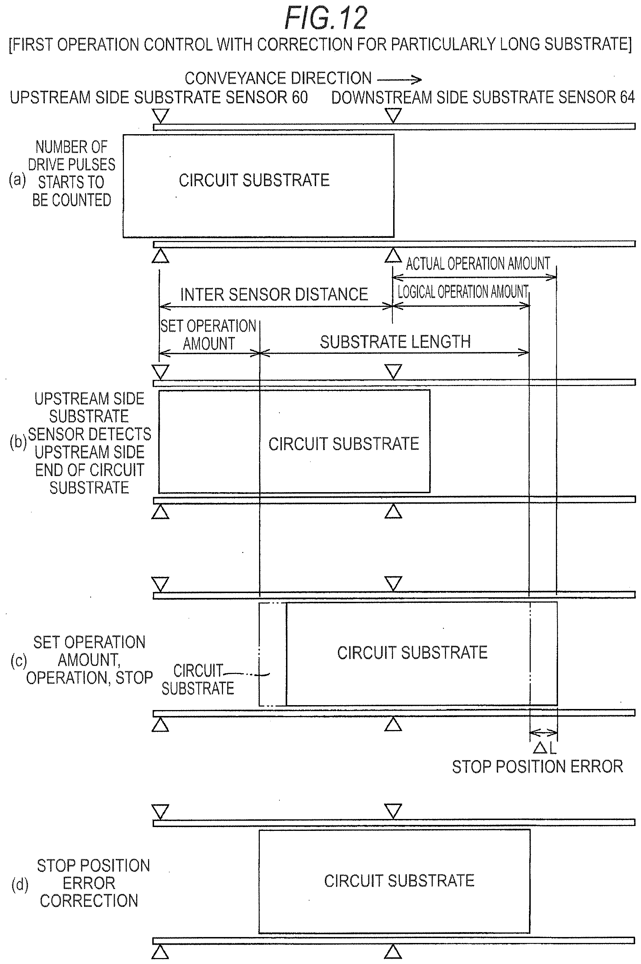

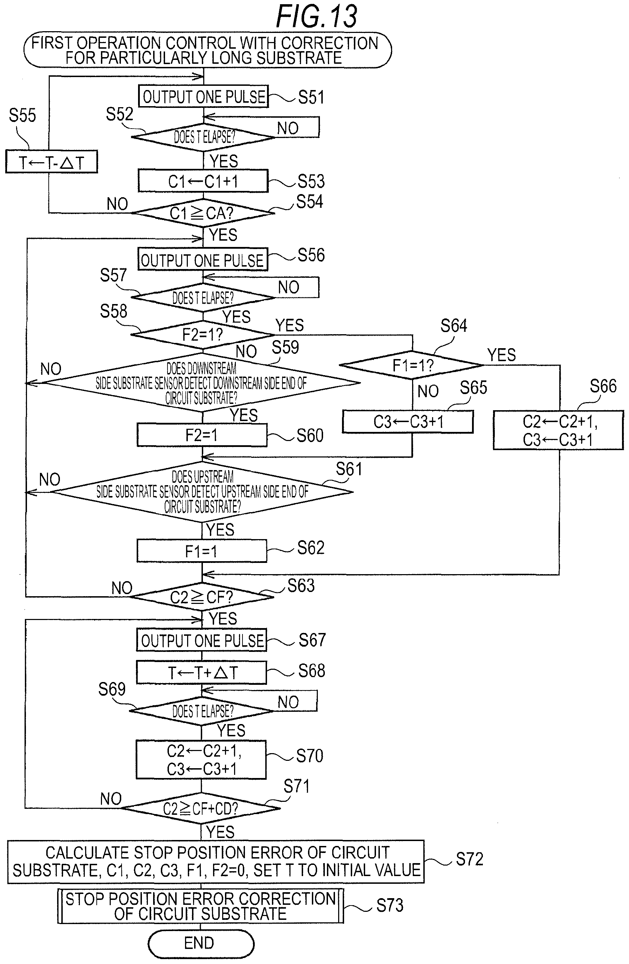

When the substrate 52 is a particularly long substrate shown in Fig. 12 and the first operation control with correction is selected (when S2 and S4 are YES in Fig. 4), the first operation control routine with correction for the particularly long substrate shown in Fig. 13 is performed. As shown in Fig. 12(a), before the upstream side end of the particularly long substrate is detected by the upstream side substrate sensor 60, the downstream side end thereof is detected by the downstream side substrate sensor 64. Therefore, after acceleration, first, it is determined whether or not the downstream side substrate sensor 64 detects the substrate downstream side end in S59. If the substrate downstream side end is detected, a flag F2 is set, and then it is determined whether or not the upstream side substrate sensor 60 detects the substrate upstream side end (S60 and S61). Thereafter, processes in S56 to S58, S64, S65, and S61 are performed until the upstream side substrate sensor 60 detects the substrate upstream side end, and it is waited that the substrate upstream side end is detected by the upstream side substrate sensor 60 while the number of output pulses, obtained after the downstream side substrate sensor 64 detects the substrate downstream side end, is counted by a third counter.

As shown in Fig. 12(b), if the substrate upstream side end is detected by the upstream side substrate sensor 60, YES is determined in S61 and a flag F1 is set (S62). Thereafter, processes in S56 to S58, S64, and S66 are performed, a pulse is output for each set time T, and the number of output pulses, obtained after the substrate upstream side end is detected by the upstream side substrate sensor 60, is counted by the second counter. The number of output pulses, obtained after the substrate downstream side end is detected, is continuously counted by a third counter (S66). If the number of output pulses, obtained after the substrate upstream side end is detected, is equal to or greater than the set number CF, YES is determined in S63, processes in S67 to S71 are performed, and the main conveyor 32 is caused to perform the deceleration operation. The set numbers CF and CD for the first operation control with correction are set as the same as in the first operation control without correction.

If the number of output pulses, obtained after the substrate upstream side end is detected, is equal to or greater than the sum of the set numbers CF and CD and the main conveyor 32 is operated by the set operation amount, the count values C1, C2, and C3 are cleared and the flags F1 and F2 are reset in S72, and the stop position error of the substrate 52 is calculated. As shown in Fig. 12(c), the stop position error ∆L is obtained by calculating the difference between the actual operation amount and the logical operation amount of the main conveyor 32 which is expressed by the count value C3. The logical operation amount is obtained by subtracting the inter sensor distance from the sum of the set operation amount and the substrate length, and is the half of the substrate length in the embodiment. The calculation is performed by converting the inter sensor distance, the substrate length, the actual operation amount, the set operation amount, and the logical operation amount into the number of pulses or the distance, and the stop position error is calculated by attaching a negative or positive mark. Further, in S73, the main conveyor 32 is operated again, the main conveyor 32 is operated in a direction in which the stop position error is eliminated by the amount of elimination, and thus the stop position error is corrected as shown in Fig. 12(d). The correction may be performed regardless of the magnitude of the stop position error. Further, the correction may be performed when the stop position error is greater than the set value and may not be performed when the stop position error is equal to or less than the set value.

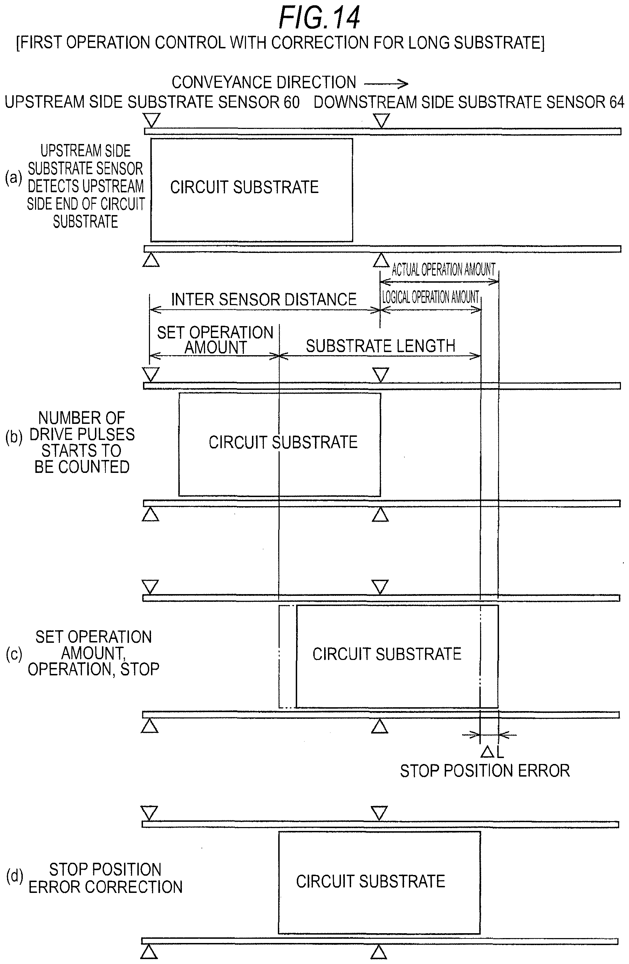

When the substrate 52 is a long substrate shown in Fig. 14 and the first operation control with correction is selected (when S2 is YES and S4 is NO in Fig.

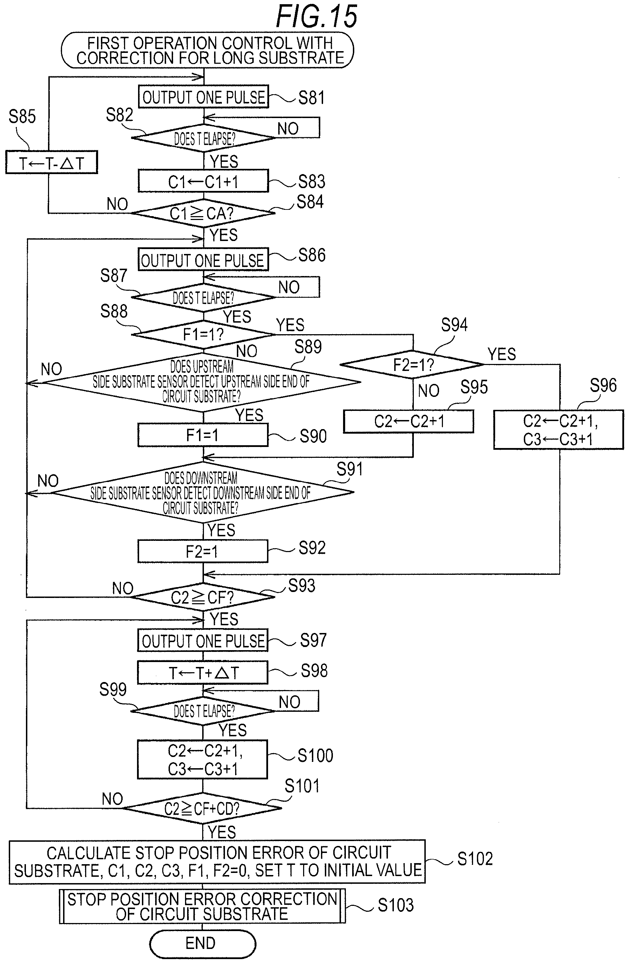

4), a first operation control routine with correction for a long substrate shown in Fig. 15 is performed. In a case of the long substrate, the upstream side end is detected by the upstream side substrate sensor 60 before the downstream side end is detected by the downstream side substrate sensor 64 as shown in Fig. 14(a), and, first, the second counter starts to count the number of output pulses (S86 to S90, and S95). Further, it is waited that the substrate downstream side end is detected by the downstream side substrate sensor 64 (S91).

If the substrate downstream side end is detected, the number of output pulses, obtained after the substrate downstream side end is detected, is counted by the third counter (S92, S94, and S96), and it is waited that the number of output pulses, obtained after the substrate upstream side end is detected, becomes the set number CF (S93). If the count value C2 becomes the set value CF, processes in S97 to S103 are performed in the same manner as the processes in S67 to S73, and the deceleration control of the main conveyor 32 is performed and the stop position error are obtained and corrected.

As understood from the above description, in the embodiment, a part of the mounting control computer 140 which performs the processes in S1, S3, and S5 to S7 forms a circuit substrate length responsive selection unit which is an operation control selection unit, a part which performs the processes in S2, S3, S5, and S6 forms a determination unit for determining operations/non-operations regarding a required stop position accuracy, a part which performs the processes in S38 to S40 forms a second operation control unit, a part which performs the processes in S26 to S37 of the first operation control routine without correction forms a first operation control unit without correction, a part which performs the processes in S63 to S71 forms a first operation control unit with correction for the particularly long substrate, a part which performs the processes in S65, S66, and S70 forms an actual operation amount detection unit, and a part which performs the process in S73 forms a correction operation unit. In addition, a part of the mounting control computer 140 which performs processes in S86 to S90, S93, and S95 to S101 forms a first operation control unit with correction for the long substrate, a part which performs processes in S96 and S100 forms an actual operation amount detection unit, and a part which performs process in S103 forms the correction operation unit.

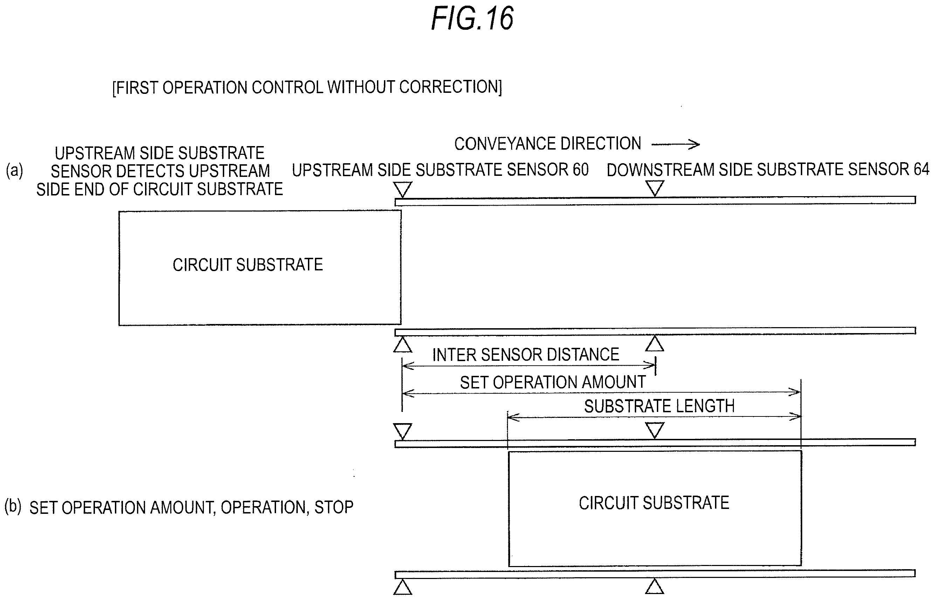

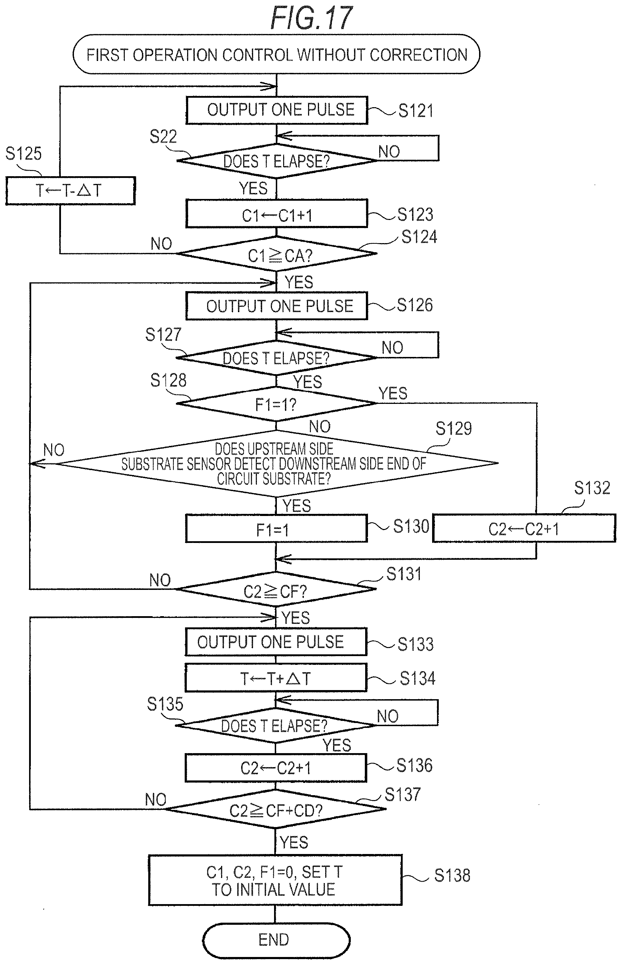

The first operation control unit may operate the belt conveyor by the set operation amount and then stop the belt conveyor after a moment that the upstream side substrate sensor detects the substrate downstream side end. An embodiment thereof will be described with reference to Figs. 16 to 19. When the first operation control without correction is selected, a routine shown in Fig. 17 is performed. The routine is configured to be the same as the first operation control routine without correction shown in Fig. 11 except that it is determined whether or not the upstream side substrate sensor 60 detects the substrate downstream side end in S129. After the downstream side end of the substrate 52 is detected as shown in Fig. 16(a), the substrate 52 stops in such a way that the main conveyor 32 is operated by the set operation amount as shown in Fig. 16(b). The set operation amount is set based on the inter sensor distance and the substrate length.

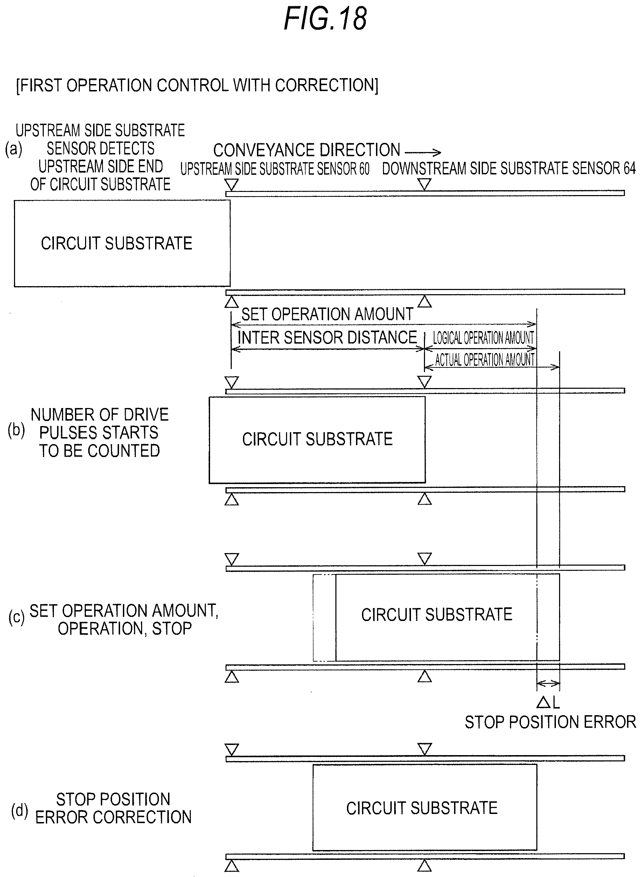

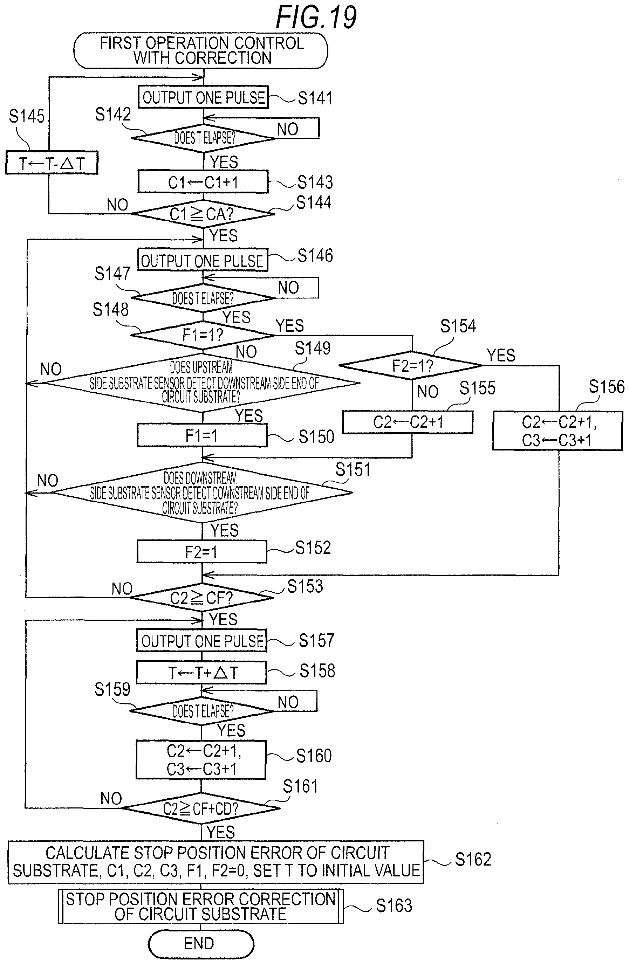

When the first operation control with correction is selected, a routine shown in Fig. 19 is performed. Since the substrate downstream side end is detected by the upstream side substrate sensor 60, a common routine is performed regardless whether or not the substrate length is longer than the inter sensor distance. Further, first, the operation is performed by the set operation amount based on the detection of the substrate downstream side end performed by the upstream side substrate sensor 60 (Fig. 18(a)). Thereafter, the actual operation amount starts to be counted based on the detection of the substrate downstream side end performed by the downstream side substrate sensor 64 (Fig. 18(b)). Therefore, the first operation control routine with correction is configured to be the same as the first operation control routine with correction for the long substrate shown in Fig. 15 except that it is determined whether or not the upstream side substrate sensor 60 detects the substrate downstream side end instead of determining whether or not the upstream side substrate sensor 60 detects the substrate upstream side end (S149) and the logical operation amount is obtained by subtracting the inter sensor distance from the set operation amount in calculation of the stop position error in S162.

In the embodiment, a part of the mounting control computer 140 which performs processes in S126 to S137 forms the first operation control unit without correction, a part which performs processes in S146 to S150, S153, and S155 to S161 forms the first operation control unit with correction, a part which performs processes in S156 and S160 forms the actual operation amount detection unit, and a part which performs a process in S163 forms a correction operation unit.

In the above-described embodiment, the substrate sensor which is provided in the main conveyor 32 includes the three substrate sensors 60, 62, and 64, the substrate sensor 60 and the substrate sensor 64 (or the substrate sensor 62 and the substrate sensor 64) from among them function as the upstream side substrate sensor and the downstream side substrate sensor respectively in the claimable invention. The sensors are used as substrate sensors for performing the second operation control, the first operation control without correction, the first operation control with correction for the particularly long substrate, and the first operation control with correction for the long substrate. However, it is possible to make at least one of the upstream side substrate sensor and the downstream side substrate sensor be dedicated to at least one of the four types of control. For example, two or more of at least one of a substrate sensor, which functions as the upstream side substrate sensor, and a substrate sensor, which functions as the downstream side substrate sensor, may be provided to be selectively used according to the length of the substrate 52, or the downstream side substrate sensor for the second operation control may be provided on the downstream side rather than the downstream side substrate sensor for the first operation control so that the substrate which stops due to the second operation control stops at the further central side of the work area of the circuit substrate work machine compared to a case in which the downstream side substrate sensor for the first operation control is shared. That is, it is possible to differentiate the downstream side substrate sensor for the second operation control from the downstream side substrate sensor for the first operation control.

In addition, as described above, the acceleration or deceleration of the substrate conveyance speed of the belt conveyor is sequentially performed. However, from a point of view of reducing a slip against the conveyor belt of the substrate as far as possible, it is preferable that the absolute value of the accelerated or decelerated speed of the conveyor belt become constant. For this reason, for example, in assumption that the conveyor belt moves by a distance $s_0$ whenever one pulse which drives the pulse motor of the belt orbiting device is output and one pulse is output whenever time $T_n$ elapses and an average speed in this case is $s_0/T_n$, an average speed difference $\alpha$ (corresponding to an acceleration and deceleration speed) which is expressed in Equation (1) below may be a constant value $\alpha_0$. The average speed difference $\alpha_0$ becomes a positive value in a case of acceleration and becomes a negative value in a case of deceleration.

$$s_0/T_{n+1} - s_0/T_n = \alpha_0 \qquad (1)$$

That is, in a program of the second operation control or the first operation control, a pulse output time interval T is set using Equation (2) whenever one pulse is output.

$$T = T/[(\alpha_0/s_0)*T+1] \qquad (2)$$

Meanwhile, as disclosed in JP-A-2004-104075, the claimable invention can be also applied for a substrate conveying device of an electronic circuit component mounting machine which is a modularized electronic circuit component mounting machine and forms a mounting system being arranged in plural in a row.

**Claims**

1. A substrate conveying device (12) comprising:

    a belt conveyor (32) that is configured to support a circuit substrate (52) using a conveyor belt (36) from a lower side and to convey the circuit substrate (52) in a conveyance direction;

an upstream side substrate sensor (60) and a downstream side substrate sensor (64) that are respectively provided at two separated places of the belt conveyor (32) in the conveyance direction, and are configured to output different signals depending on whether the circuit substrate (52) is detected or is not detected; a first operation control unit that is configured to operate the belt conveyor (32) by a set operation amount and to stop the belt conveyor (32), after a moment in which the upstream side substrate sensor (60) detects an upstream side end or a downstream side end of the circuit substrate (52) in the conveyance direction;

a second operation control unit that is configured to stop the operation of the belt conveyor (32) according to detection of the downstream side end of the circuit substrate (52) performed by the downstream side substrate sensor (64); and an operation control selection unit that is capable of selecting the first operation control unit or the second operation control unit.

2. The substrate conveying device (12) according to claim 1,

wherein the first operation control unit is configured to operate the belt conveyor (32) by the set operation amount and to stop the belt conveyor (32), after the moment in which the upstream side substrate sensor (60) detects the upstream side end of the circuit substrate (52) in the conveyance direction, and

wherein the substrate conveying device (12) further comprises:

an actual operation amount detection unit that is configured to detect an actual operation amount of the belt conveyor (32) from a moment in which the downstream side end of the circuit substrate (52) is detected by the downstream side substrate sensor (64) while the belt conveyor (32) is being operated by the first operation control unit; and

a correction operation unit that is configured to operate the belt conveyor (32) again and stops the belt conveyor (32), after the first operation control unit stops the operation of the belt conveyor (32), in order to reduce a difference between the actual operation amount, which is detected by the actual operation amount detection unit, and a logical operation amount, which is determined based on (a) the set operation amount, (b) a substrate length which is a distance between the upstream side end and the downstream side end of the circuit substrate (52) in the conveyance direction, and (c) a distance between the upstream side substrate sensor (60) and the downstream side substrate sensor (64) in the conveyance direction.

3. The substrate conveying device (12) according to claim 1,

wherein the first operation control unit is configured to operate the belt conveyor (32) by the set operation amount and to stop the belt conveyor (32), after the moment in which the upstream side substrate sensor (60) detects the downstream side end of the circuit substrate (52) in the conveyance direction, and

wherein the substrate conveying device (12) further comprises:

an actual operation amount detection unit that is configured to detect an actual operation amount of the belt conveyor (32) from a moment in which the downstream side end of the circuit substrate (52) is detected by the downstream side substrate sensor (64) while the belt conveyor (32) is being operated by the first operation control unit; and

a correction operation unit that is configured to operate the belt conveyor (32) again and to stop the belt conveyor (32), after the first operation control unit stops the operation of the belt conveyor (32), in order to reduce a difference between the actual operation amount, which is detected by the actual operation amount detection unit, and a logical operation amount, which is determined based on (a) the set operation amount and (b) a distance between the upstream side substrate sensor (60) and the downstream side substrate sensor (64) in the conveyance direction.

4. The substrate conveying device (12) according to claim 2 or 3, further comprising: a determination unit for determining operations/non-operations regarding a required stop position accuracy that is configured to determine operations of the actual operation amount detection unit and the correction operation unit when the circuit substrate (52), which is conveyed by the belt conveyor (32), requires a higher stop position accuracy than a set accuracy, and that is configured to determine non-operations of the actual operation amount detection unit and the correction operation unit when the circuit substrate (52) does not require the higher stop position accuracy than the set accuracy under a condition in which the first operation control unit is selected by the operation control selection unit.

5. The substrate conveying device (12) according to any one of claims 1 to 4, further comprising: a circuit substrate length responsive selection unit in which the operation control selection unit is configured to select the first operation control unit when the substrate length, which is the distance between the upstream side end and the downstream side end of the circuit substrate (52) in the conveyance direction, is longer than a set length, and to select the second operation control unit when the substrate length is equal to or less than the set length.

6. The substrate conveying device (12) according to claim 5, wherein the downstream side substrate sensor is installed in a position corresponding to a middle point between the upstream side end and the downstream side end of the circuit substrate (52) in the conveyance direction in a position where a circuit substrate (52) which has a substrate length longer than the set length is to be stopped, and wherein the set operation amount is set so that the middle point comes into a position corresponding to the downstream side substrate sensor (64).

**Patentansprüche**

1. Eine Substratfördervorrichtung (12) umfassend:

einen Bandförderer (32), der konfiguriert ist, ein Schaltungssubstrat (52) unter Verwendung eines Förderbandes (36) von einer unteren Seite zu stützen und das Schaltungssubstrat (52) in einer Förderrichtung zu befördern; einen stromaufwärtsseitigen Substratsensor (60) und einen stromabwärtsseitigen Substratsensor (64), die jeweils an zwei getrennten Stellen des Bandförderers (32) in der Förderrichtung bereitgestellt sind und konfiguriert sind, unterschiedliche Signale abhängig davon, ob das Schaltungssubstrat (42) detektiert wird oder nicht detektiert wird, auszugeben; eine erste Betriebssteuereinheit, die konfiguriert ist, den Bandförderer (32) um einen eingestellten Betriebsbetrag zu betreiben und den Bandförderer (32) nach einem Moment anzuhalten, in welchem der stromaufwärtsseitige Substratsensor (60) ein stromaufwärtsseitiges Ende oder ein stromabwärtsseitiges Ende des Schaltungssubstrats (52) in der Förderrichtung detektiert; eine zweite Betriebssteuereinheit, die konfiguriert ist, den Betrieb des Bandförderers (32) gemäß einer Detektion des stromabwärtsseitigen Endes des Schaltungssubstrats (52), die von dem stromabwärtsseitigen Substratsensor (64) ausgeführt wird, anzuhalten; und eine Betriebssteuerungs-Auswahleinheit, die in der Lage ist, die erste Betriebssteuereinheit oder die zweite Betriebssteuereinheit auszuwählen.

2. Die Substratfördervorrichtung (12) gemäß Anspruch 1, wobei die erste Betriebssteuereinheit konfiguriert ist, den Bandförderer (32) um den eingestellten Betriebsbetrag zu betreiben und den Bandförderer (32) nach dem Moment anzuhalten, in welchem der stromaufwärtsseitige Substratsensor (60) das stromaufwärtsseitige Ende des Schaltungssubstrats (52) in der Förderrichtung detektiert, und wobei die Substratfördervorrichtung (12) ferner umfasst:

eine Ist-Betätigungsbetrags-Erfassungseinheit, die konfiguriert ist, einen Ist-Betätigungsbetrag des Bandförderers (32) von einem Moment an zu erfassen, in dem das stromabwärtsseitige Ende des Schaltungssubstrats (52) durch den stromabwärtsseitigen Substratsensor (64) erfasst wird, während der Bandförderer (32) von der ersten Betriebssteuereinheit betrieben wird; und eine Korrekturbetriebseinheit, die konfiguriert ist, den Bandförderer (32) erneut zu betreiben und den Bandförderer (32) anhält, nachdem die erste Betriebssteuereinheit den Betrieb des Bandförderers (32) anhält, um eine Differenz zwischen dem Ist-Betriebsbetrag, der von der Ist-Betätigungsbetrags-Erfassungseinheit erfasst wird, und einem logischen Betriebsbetrag zu reduzieren, der basierend auf (a) dem eingestellten Betriebsbetrag, (b) einer Substratlänge, die ein Abstand zwischen dem stromaufwärtsseitigen Ende und der stromabwärtsseitigen Ende des Schaltungssubstrats (52) in der Förderrichtung ist, und (c) einem Abstand zwischen dem stromaufwärtsseitigen Substratsensor (60) und dem stromabwärtsseitigen Substratsensor (64) in der Förderrichtung bestimmt wird.

3. Die Substratfördervorrichtung (12) gemäß Anspruch 1, wobei die erste Betriebssteuereinheit konfiguriert ist, den Bandförderer (32) um den eingestellten Betriebsbetrag zu betreiben und den Bandförderer (32) nach dem Moment anzuhalten, in welchem der stromaufwärtsseitige Substratsensor (60) das stromabwärtsseitige Ende des Schaltungssubstrats (52) in der Förderrichtung detektiert, und wobei die Substratfördervorrichtung (12) ferner umfasst:

eine Ist-Betätigungsbetrags-Erfassungseinheit, die konfiguriert ist, einen Ist-Betätigungsbetrag des Bandförderers (32) von einem Moment an zu erfassen, in dem das stromabwärtsseitige Ende des Schaltungssubstrats (52) durch den stromabwärtsseitigen Substratsensor (64) erfasst wird, während der Bandförderer (32) von der ersten Betriebssteuereinheit betrieben wird; und

eine Korrekturbetriebseinheit, die konfiguriert ist, den Bandförderer (32) erneut zu betreiben und den Bandförderer (32) anzuhalten, nachdem die erste Betriebssteuereinheit den Betrieb des Bandförderers (32) anhält, um eine Differenz zwischen dem Ist-Betriebsbetrag, der von der Ist-Betätigungsbetrags-Erfassungseinheit erfasst wird, und einem logischen Betriebsbetrag zu reduzieren, der basierend auf (a) dem eingestellten Betriebsbetrag und (b) einem Abstand zwischen dem stromaufwärtsseitigen Substratsensor (60) und dem stromabwärtsseitigen Substratsensor (64) in der Förderrichtung bestimmt wird.

4. Die Substratfördervorrichtung (12) gemäß Anspruch 2 oder 3, ferner umfassend: eine Bestimmungseinheit zum Bestimmen von Operationen/Nicht-Operationen bezüglich einer erforderlichen Anhaltepositionsgenauigkeit, die konfiguriert ist, Operationen der Ist-Betriebsbetrags-Erfassungseinheit und der Korrekturbetriebseinheit zu bestimmen, wenn das Schaltungssubstrat (52), das von dem Bandförderer (32) gefördert wird, eine höhere Anhaltepositionsgenauigkeit als eine eingestellte Genauigkeit benötigt und welche konfiguriert ist, Nicht-Operationen der Ist-Betätigungsbetrags-Erfassungseinheit und der Korrekturbetriebseinheit zu bestimmen, wenn das Schaltungssubstrat (52) die Anhaltepositionsgenauigkeit, die höher als die eingestellte Genauigkeit ist, in einem Zustand nicht benötigt, in dem die erste Betriebssteuereinheit von der Betätigungssteuerungs-Auswahleinheit ausgewählt ist.

5. Die Substratfördervorrichtung (12) gemäß einem der Ansprüche 1 bis 4, ferner umfassend: eine auf die Schaltungssubstratlänge ansprechende Auswahleinheit, in der die Betriebssteuerungs-Auswahleinheit konfiguriert ist, die erste Betriebssteuereinheit auszuwählen, wenn die Substratlänge, die der Abstand zwischen dem stromaufwärtsseitigen Ende und dem stromabwärtsseitigen Ende des Schaltungssubstrats (52) in der Förderrichtung ist, länger als eine festgelegte Länge ist und die zweite Betriebssteuereinheit auszuwählen, wenn die Substratlänge gleich wie oder geringer als die festgelegte Länge ist.

6. Die Substratfördervorrichtung (12) gemäß Anspruch 5, wobei der stromabwärtsseitige Substratsensor in einer Position installiert ist, die einem Mittelpunkt zwischen dem stromaufwärtsseitigen Ende und dem stromabwärtsseitigen Ende des Schaltungssubstrats (52) in der Förderrichtung entspricht, in einer Position, wo ein Schaltungssubstrat (52), welches eine Substratlänge aufweist, die länger als die eingestellte Länge ist, anzuhalten ist und wobei der eingestellte Betriebsbetrag so eingestellt ist, dass der Mittelpunkt in eine Position kommt, die dem stromabwärtsseitigen Substratsensor (64) entspricht.

## Revendications

1. Dispositif de convoyage de substrat (12) comprenant :

un convoyeur à bande (32) qui est configuré pour soutenir un substrat de circuits (52) au moyen d'une bande de convoyeur (36) depuis un côté inférieur et pour convoyer le substrat de circuits (52) dans une direction de convoyage ; un capteur de substrat de côté amont (60) et un capteur de substrat de côté aval (64) qui sont respectivement installés à deux emplacements séparés du convoyeur à bande (32) dans la direction de convoyage, et sont configurés pour émettre différents signaux selon que le substrat de circuits (52) est détection ou n'est pas détecté ; une première unité de contrôle de fonctionnement qui est configurée pour faire fonctionner le convoyeur à bande (32) selon une quantité de fonctionnement définie et pour arrêter le convoyeur à bande (32) après un moment où le capteur de substrat de côté amont (60) détecte une extrémité de côté amont ou une extrémité de côté aval du substrat de circuits (52) dans la direction de convoyage ; une deuxième unité de contrôle de fonctionnement qui est configurée pour arrêter le fonctionnement du convoyeur à bande (32) selon une détection de l'extrémité de côté aval du substrat de circuits (52) effectuée par le capteur de substrat de côté aval (64) ; et une unité de sélection de contrôle de fonctionnement qui est capable d'une sélection de la première unité de contrôle de fonctionnement ou la deuxième unité de contrôle de fonctionnement.

2. Le dispositif de convoyage de substrat selon la revendication 1, dans lequel la première unité de contrôle de fonctionnement est configurée pour faire fonctionner le convoyeur à bande (32) selon la quantité de fonctionnement définie et pour arrêter le convoyeur à bande (32), après le moment où le capteur de substrat de côté amont (60) détecte l'extrémité de côté amont du substrat de circuits (52) dans la direction de convoyage, et dans lequel le dispositif de convoyage de substrat (12) comprend en outre :

une unité de détection de quantité de fonctionnement réelle qui est configurée pour détecter une quantité de fonctionnement réelle du convoyeur à bande (32) à partir d'un moment où l'extrémité de côté aval du substrat de circuits (52) est détectée par le capteur de substrat de côté aval (64) tandis que la première unité de contrôle de fonctionnement fait fonctionner le convoyeur à bande (32) ; et

une unité de fonctionnement de correction qui est configurée pour faire fonctionner le convoyeur à bande (32) à nouveau et arrêter le convoyeur à bande (32), après que la première unité de contrôle de fonctionnement arrête le fonctionnement du convoyeur à bande (32),

afin de réduire une différence entre la quantité de fonctionnement réelle, qui est détectée par l'unité de détection de quantité de fonctionnement réelle, et une quantité de fonctionnement logique, qui est déterminée en fonction de (a) la quantité de fonctionnement définie, (b) une longueur de substrat qui est une distance entre l'extrémité de côté amont et l'extrémité côté avant du substrat de circuits (52) dans la direction de convoyage, et (c) une distance entre le capteur de substrat de côté amont (60) et le capteur de substrat de côté aval (64) dans la direction de convoyage.

**3.** Le dispositif de convoyage de substrat (12) selon la revendication 1,
dans lequel la première unité de contrôle de fonctionnement est configurée pour faire fonctionner le convoyeur à bande (32) selon la quantité de fonctionnement définie et pour arrêter le convoyeur à bande (32); après le moment où le capteur de substrat de côté amont (60) détecte l'extrémité de côté aval du substrat de circuits (52) dans la direction de convoyage, et
dans lequel le dispositif de convoyage de substrat (12) comprend en outre :

une unité de détection de quantité de fonctionnement réelle qui est configurée pour détecter une quantité de fonctionnement réelle du convoyeur à bande (32) à partir d'un moment où l'extrémité de côté aval du substrat de circuits (52) est détectée par le capteur de substrat de côté aval (64) tandis que la première unité de contrôle de fonctionnement fait fonctionner le convoyeur à bande (32) ; et
une unité de fonctionnement de correction qui est configurée pour faire fonctionner le convoyeur à bande (32) à nouveau et arrêter le convoyeur à bande (32), après que la première unité de contrôle de fonctionnement arrête le fonctionnement du convoyeur à bande (32), afin de réduire une différence entre la quantité de fonctionnement réelle, qui est détectée par l'unité de détection de quantité de fonctionnement réelle, et une quantité de fonctionnement logique, qui est déterminée en fonction de

(a) la quantité de fonctionnement définie et
(b) une distance entre le capteur de substrat de côté amont (60) et le capteur de substrat de côté aval (64) dans la direction de convoyage.

**4.** Le dispositif de convoyage de substrat(12) selon la revendication 2 ou 3, comprenant en outre :
une unité de détermination pour une détermination d'opérations/non-opérations relatives à une précision de position d'arrêt requise qui est configurée pour déterminer des opérations de l'unité de détection de quantité de fonctionnement réelle et l'unité de fonctionnement de correction lorsque le substrat de circuits (52), qui est convoyé par le convoyeur à bande (32), requiert une précision de position d'arrêt supérieure à une précision définie, et qui est configurée pour déterminer des non-opérations de l'unité de détection de quantité de fonctionnement réelle et l'unité de fonctionnement de correction lorsque le substrat de circuits (52) ne requiert pas la précision de position d'arrêt supérieure à la précision définie selon une condition dans laquelle la première unité de contrôle de fonctionnement est sélectionnée par l'unité de sélection de contrôle de fonctionnement.

**5.** Le dispositif de convoyage de substrat (12) selon l'une quelconque des revendications 1 à 4, comprenant en outre :
une unité de sélection réactive à la longueur de substrat de circuits dans laquelle l'unité de sélection de contrôle de fonctionnement est configurée pour sélectionner la première unité de contrôle de fonctionnement lorsque la longueur de substrat, qui est la distance entre l'extrémité de côté amont et l'extrémité de côté aval du substrat de circuits (52) dans la direction de convoyage, est supérieure à une longueur définie, et pour sélectionner la deuxième unité de contrôle de fonctionnement lorsque la longueur de substrat est inférieure ou égale à la longueur définie.

**6.** Le dispositif de convoyage de substrat (12) selon la revendication 5, dans lequel le capteur de substrat de côté aval est installé dans une position correspondant à un point médian entre l'extrémité de côté amont et l'extrémité de côté aval du substrat de circuits (52) dans la direction de convoyage dans une position où un substrat de circuits (52) qui présente une longueur de substrat supérieure à la longueur définie doit être arrêté, et dans lequel la quantité de fonctionnement définie est définie de sorte que le point médian arrive à une position correspondant au capteur de substrat de côté aval (64).

FIG.1

*FIG.2*

A-A CROSS SECTION

(b)

(a)

## FIG.3

REFERENCE MARK IMAGING DEVICE — 22

IMAGE PROCESSING COMPUTER — 144

COMPONENT IMAGING DEVICE — 24

SUBSTRATE SENSOR — 60

SUBSTRATE SENSOR — 62

SUBSTRATE SENSOR — 64

140

26

CPU

ROM

RAM

INPUT/OUTPUT UNIT

DRIVE CIRCUIT — 142 → SUBSTRATE HOLDING DEVICE — 14

DRIVE CIRCUIT — 142 → COMPONENT SUPPLY DEVICE — 16

DRIVE CIRCUIT — 142 → ELECTRIC MOTOR — 50

DRIVE CIRCUIT — 142 → ELECTRIC MOTOR — 50

DRIVE CIRCUIT — 142 → ELECTRIC MOTOR — 50

DRIVE CIRCUIT — 142 → MOUNTING HEAD — 100

DRIVE CIRCUIT — 142 → ELECTRIC MOTOR — 114

DRIVE CIRCUIT — 142 → ELECTRIC MOTOR — 124

EP 2 819 497 B1

## FIG.4

## FIG.5

## FIG.6

[SECOND OPERATION CONTROL]

CONVEYANCE DIRECTION ⟶

UPSTREAM SIDE SUBSTRATE SENSOR 60

DOWNSTREAM SIDE SUBSTRATE SENSOR 64

CIRCUIT SUBSTRATE

(a) UPSTREAM SIDE SUBSTRATE SENSOR DETECTS UPSTREAM SIDE END OF CIRCUIT SUBSTRATE

SUBSTRATE LENGTH

INTER SENSOR DISTANCE

CIRCUIT SUBSTRATE

(b) DOWNSTREAM SIDE SUBSTRATE SENSOR DETECTS DOWNSTREAM SIDE END OF CIRCUIT SUBSTRATE

# FIG.7

```
                    ( SECOND OPERATION CONTROL )
                                │
                    ┌──────────►│◄────────────┐
                    │   ┌─────────────────┐    │
                    │   │ OUTPUT ONE PULSE│~S21│
                    │   └─────────────────┘    │
              S22   │           │              │
         ┌──────────┼───────────┴──────────┐   │
         │          │  ◇ DOES T ELAPSE? ◇───┼───┘ NO
    S25  │          │           │ YES
   ┌─────┴───┐      │   ┌─────────────────┐
   │ T←T-△T  │      │   │   C1←C1+1       │~S23
   └─────────┘      │   └─────────────────┘
         ▲   NO     │           │           S24
         └──────────◇  C1≧CA?  ◇
                    │           │ YES
        ┌──────────►│
        │   ┌─────────────────┐
        │   │ OUTPUT ONE PULSE│~S26
        │   └─────────────────┘
    S27 │           │                 NO
        │  ◇ DOES T ELAPSE? ◇──────────┐
    S28 │           │ YES              │
        │  ◇     F1=1?      ◇──YES──────┼──────┐
        │           │ NO                       │
   NO   │     S29   │                          │
   ◄────◇ DOES UPSTREAM                  S32   │
        │ SIDE SUBSTRATE SENSOR DETECT          │
        │ UPSTREAM SIDE END OF           ┌──────┴──────┐
        │ CIRCUIT SUBSTRATE? ◇           │  C2←C2+1    │
        │           │ YES                └──────┬──────┘
        │   ┌─────────────────┐                 │
        │   │     F1=1        │~S30             │
        │   └─────────────────┘                 │
        │     S31   │◄──────────────────────────┘
   NO   │           │
   ◄────◇   C2≧CF? ◇ S31
        │           │ YES
        ┌──────────►│
        │   ┌─────────────────┐
        │   │ OUTPUT ONE PULSE│~S33
        │   └─────────────────┘
        │   ┌─────────────────┐
        │   │    T←T+△T       │~S34
        │   └─────────────────┘
    S35 │           │                 NO
        │  ◇ DOES T ELAPSE? ◇──────────┐
        │           │ YES              │
        │   ┌─────────────────┐◄───────┘
        │   │    C2←C2+1      │~S36
        │   └─────────────────┘
   NO   │           │           S37
   ◄────◇  C2≧CF+CD? ◇
                    │ YES ◄─────────────────────┐
           S38      │                           │
       ◇ DOES DOWNSTREAM                   NO   │   S39
       SIDE SUBSTRATE SENSOR DETECT ◇───────────┤
       DOWNSTREAM SIDE END              ┌────────┴────────┐
       OF CIRCUIT SUBSTRATE? ◇          │ OUTPUT ONE PULSE│
                    │ YES               └────────┬────────┘
                    │                       S40  │
                    │              NO  ◇ DOES T ELAPSE? ◇
                    │              ┌───◇              ◇
                    │              │        │ YES
   ┌─────────────────────────┐     └────────┘
   │ C1, C2, F1=0, SET T     │~S41
   │ TO INITIAL VALUE        │
   └─────────────────────────┘
                    │
              (  END  )
```

# FIG.8

ACCELERATION

(a)

SPEED

CA

NUMBER OF PULSES

DECELERATION

(b)

SPEED

CF          CD

NUMBER OF
PULSES

UPSTREAM SIDE SUBSTRATE
SENSOR DETECTS UPSTREAM SIDE
END OF CIRCUIT SUBSTRATE

# FIG.9

[FIRST OPERATION CONTROL WITHOUT CORRECTION]

CONVEYANCE DIRECTION ⟶

UPSTREAM SIDE SUBSTRATE SENSOR 60    DOWNSTREAM SIDE SUBSTRATE SENSOR 64

(a) UPSTREAM SIDE SUBSTRATE SENSOR DETECTS UPSTREAM SIDE END OF CIRCUIT SUBSTRATE

CIRCUIT SUBSTRATE

INTER SENSOR DISTANCE

SET OPERATION AMOUNT

SUBSTRATE LENGTH

(b) SET OPERATION AMOUNT, OPERATION, STOP

CIRCUIT SUBSTRATE

# FIG.10

[FIRST OPERATION CONTROL WITHOUT CORRECTION]

CONVEYANCE DIRECTION ⟶

UPSTREAM SIDE SUBSTRATE SENSOR 60    DOWNSTREAM SIDE SUBSTRATE SENSOR 64

(a) UPSTREAM SIDE SUBSTRATE SENSOR DETECTS UPSTREAM SIDE END OF CIRCUIT SUBSTRATE

CIRCUIT SUBSTRATE

INTER SENSOR DISTANCE

SET OPERATION AMOUNT

SUBSTRATE LENGTH

(b) SET OPERATION AMOUNT, OPERATION, STOP

CIRCUIT SUBSTRATE

23

# FIG.11

```
( FIRST OPERATION CONTROL WITHOUT CORRECTION )
                            │
                            ▼
                ┌──────────────────────┐
                │   OUTPUT ONE PULSE    │──S21
                └──────────────────────┘
                            │
         S22        ┌───────────────┐   NO
            ◇───────│ DOES T ELAPSE?│───────►
                    └───────────────┘
                         │ YES
                ┌──────────────────────┐
                │      C1←C1+1          │──S23
                └──────────────────────┘
                            │            S24
         NO         ┌───────────────┐
     ◄──────────────│    C1≧CA?     │
  ┌──────────┐      └───────────────┘
  │  T←T-△T  │──S25      │ YES
  └──────────┘           ▼
                ┌──────────────────────┐
                │   OUTPUT ONE PULSE    │──S26
                └──────────────────────┘
                            │
         S27        ┌───────────────┐   NO
            ◇───────│ DOES T ELAPSE?│───────►
                    └───────────────┘
                         │ YES
         S28        ┌───────────────┐   YES
            ◇───────│     F1=1?     │───────────►
                    └───────────────┘
                         │ NO              S29
         NO    ◇─────────────────────────────────◇
     ◄─────────│ DOES UPSTREAM SIDE SUBSTRATE    │
               │ SENSOR DETECT UPSTREAM SIDE END │
               │   OF CIRCUIT SUBSTRATE?         │
               └─────────────────────────────────┘
                         │ YES                      S32
                ┌──────────────────────┐    ┌──────────────┐
                │        F1=1          │──S30│   C2←C2+1    │
                └──────────────────────┘    └──────────────┘
                            │                      │
         NO         ┌───────────────┐   S31
     ◄──────────────│    C2≧CF?     │
                    └───────────────┘
                         │ YES
                ┌──────────────────────┐
                │   OUTPUT ONE PULSE    │──S33
                └──────────────────────┘
                ┌──────────────────────┐
                │      T←T+△T          │──S34
                └──────────────────────┘
                            │
         S35        ┌───────────────┐   NO
            ◇───────│ DOES T ELAPSE?│───────►
                    └───────────────┘
                         │ YES
                ┌──────────────────────┐
                │      C2←C2+1          │──S36
                └──────────────────────┘
                            │            S37
         NO         ┌───────────────┐
     ◄──────────────│   C2≧CF+CD?   │
                    └───────────────┘
                         │ YES
                ┌──────────────────────┐
                │ C1, C2, F1=0, SET T  │──S41
                │    TO INITIAL VALUE   │
                └──────────────────────┘
                            │
                      (   END   )
```

# FIG.12

[FIRST OPERATION CONTROL WITH CORRECTION FOR PARTICULARLY LONG SUBSTRATE]

CONVEYANCE DIRECTION ⟶

UPSTREAM SIDE SUBSTRATE SENSOR 60      DOWNSTREAM SIDE SUBSTRATE SENSOR 64

(a) NUMBER OF DRIVE PULSES STARTS TO BE COUNTED

CIRCUIT SUBSTRATE

ACTUAL OPERATION AMOUNT

INTER SENSOR DISTANCE      LOGICAL OPERATION AMOUNT

SET OPERATION AMOUNT      SUBSTRATE LENGTH

(b) UPSTREAM SIDE SUBSTRATE SENSOR DETECTS UPSTREAM SIDE END OF CIRCUIT SUBSTRATE

CIRCUIT SUBSTRATE

(c) SET OPERATION AMOUNT, OPERATION, STOP

CIRCUIT SUBSTRATE

CIRCUIT SUBSTRATE

ΔL

STOP POSITION ERROR

(d) STOP POSITION ERROR CORRECTION

CIRCUIT SUBSTRATE

## FIG.13

FIRST OPERATION CONTROL WITH CORRECTION
FOR PARTICULARLY LONG SUBSTRATE

OUTPUT ONE PULSE — S51

S52 — DOES T ELAPSE? → NO

YES

C1←C1+1 — S53

S54 — C1≧CA? → NO

YES

S55 — T←T−△T

OUTPUT ONE PULSE — S56

S57 — DOES T ELAPSE? → NO

YES

S58 — F2=1? → YES

NO — S59

DOES DOWNSTREAM SIDE SUBSTRATE SENSOR DETECT DOWNSTREAM SIDE END OF CIRCUIT SUBSTRATE? → NO

YES

F2=1 — S60

S61 — DOES UPSTREAM SIDE SUBSTRATE SENSOR DETECT UPSTREAM SIDE END OF CIRCUIT SUBSTRATE? → NO

YES

F1=1 — S62

S63 — C2≧CF? → NO

YES

S64 — F1=1? → YES

NO — S65

C3←C3+1

S66 — C2←C2+1, C3←C3+1

OUTPUT ONE PULSE — S67

T←T+△T — S68

S69 — DOES T ELAPSE? → NO

YES

C2←C2+1, C3←C3+1 — S70

S71 — C2≧CF+CD? → NO

YES

CALCULATE STOP POSITION ERROR OF CIRCUIT SUBSTRATE, C1, C2, C3, F1, F2=0, SET T TO INITIAL VALUE — S72

STOP POSITION ERROR CORRECTION OF CIRCUIT SUBSTRATE — S73

END

# FIG.14

## [FIRST OPERATION CONTROL WITH CORRECTION FOR LONG SUBSTRATE]

CONVEYANCE DIRECTION ———>

UPSTREAM SIDE SUBSTRATE SENSOR 60    DOWNSTREAM SIDE SUBSTRATE SENSOR 64

(a) UPSTREAM SIDE SUBSTRATE SENSOR DETECTS UPSTREAM SIDE END OF CIRCUIT SUBSTRATE

CIRCUIT SUBSTRATE

ACTUAL OPERATION AMOUNT

INTER SENSOR DISTANCE    LOGICAL OPERATION AMOUNT

SET OPERATION AMOUNT    SUBSTRATE LENGTH

(b) NUMBER OF DRIVE PULSES STARTS TO BE COUNTED

CIRCUIT SUBSTRATE

(c) SET OPERATION AMOUNT, OPERATION, STOP

CIRCUIT SUBSTRATE

$\triangle L$

STOP POSITION ERROR

(d) STOP POSITION ERROR CORRECTION

CIRCUIT SUBSTRATE

# FIG.15

```
        ( FIRST OPERATION CONTROL WITH )
        ( CORRECTION FOR LONG SUBSTRATE )
                        │
                        ▼
              ┌──────────────────┐
              │ OUTPUT ONE PULSE │──S81
              └──────────────────┘
                        │◄──────────── NO
S85         S82         ▼
             ◇ DOES T ELAPSE? ◇───────
              └──────────────┘
   ┌──────────┐        │ YES
   │ T←T−△T   │   ┌──────────────┐
   └──────────┘   │  C1←C1+1     │──S83
                  └──────────────┘
         NO                │         S84
    ◄────────── ◇ C1≧CA? ◇──────
                           │ YES
                           ▼
              ┌──────────────────┐
              │ OUTPUT ONE PULSE │──S86
              └──────────────────┘
                        │◄──────────── NO
S87                     ▼
         ◇ DOES T ELAPSE? ◇──────────
          └──────────────┘
S88                │ YES      YES              S94
    ◇──── F1=1? ────────────────────┐       ◇── F2=1? ──── YES ──┐
     └──────┘                        │        └──────┘           │
  NO       │ NO        S89           ▼    NO    S95        S96    │
    ◇ DOES UPSTREAM              ◇ F2=1? ◇      ┌──────────┐  ┌──────────┐
 ◄─ SIDE SUBSTRATE SENSOR DETECT UPSTREAM SIDE END OF      │  │ C2←C2+1, │
    CIRCUIT SUBSTRATE? ◇            │ NO         │C2←C2+1│  │ C3←C3+1  │
          │ YES                     └───────────└────────┘  └──────────┘
     ┌──────────┐                                   │
     │  F1=1    │──S90                               │
     └──────────┘                                    │
          │◄──────────────────────────────── S91     │
  NO      ▼                                          │
    ◇ DOES DOWNSTREAM                                │
 ◄─ SIDE SUBSTRATE SENSOR DETECT DOWNSTREAM SIDE END OF
    CIRCUIT SUBSTRATE? ◇
          │ YES
     ┌──────────┐
     │  F2=1    │──S92
     └──────────┘
          │◄────────────────────── S93
  NO      ▼
    ◇ C2≧CF? ◇──────
          │ YES
          ▼
   ┌──────────────────┐
   │ OUTPUT ONE PULSE │──S97
   └──────────────────┘
          ▼
   ┌──────────────────┐
   │    T←T+△T        │──S98
   └──────────────────┘
S99       │◄──────────── NO
    ◇ DOES T ELAPSE? ◇────
          │ YES
   ┌──────────────┐
   │  C2←C2+1,    │──S100
   │  C3←C3+1     │
   └──────────────┘       S101
  NO      ▼
    ◇ C2≧CF+CD? ◇──────
          │ YES
   ┌─────────────────────────────────────────────┐
   │ CALCULATE STOP POSITION ERROR OF CIRCUIT     │──S102
   │ SUBSTRATE, C1, C2, C3, F1, F2=0, SET T TO INITIAL VALUE │
   └─────────────────────────────────────────────┘
   ┌─────────────────────────────────────────────┐
   │ STOP POSITION ERROR CORRECTION               │──S103
   │ OF CIRCUIT SUBSTRATE                         │
   └─────────────────────────────────────────────┘
                     │
                 ( END )
```

# FIG.16

[FIRST OPERATION CONTROL WITHOUT CORRECTION]

CONVEYANCE DIRECTION ⟶

(a) UPSTREAM SIDE SUBSTRATE SENSOR DETECTS UPSTREAM SIDE END OF CIRCUIT SUBSTRATE

UPSTREAM SIDE SUBSTRATE SENSOR 60    DOWNSTREAM SIDE SUBSTRATE SENSOR 64

CIRCUIT SUBSTRATE

INTER SENSOR DISTANCE

SET OPERATION AMOUNT

SUBSTRATE LENGTH

(b) SET OPERATION AMOUNT, OPERATION, STOP

CIRCUIT SUBSTRATE

EP 2 819 497 B1

## FIG.17

```
FIRST OPERATION CONTROL WITHOUT CORRECTION
```

OUTPUT ONE PULSE — S121

S22 — DOES T ELAPSE? — NO

YES

C1←C1+1 — S123

S125 — T←T−△T

C1≧CA? — S124 — NO

YES

OUTPUT ONE PULSE — S126

S127 — DOES T ELAPSE? — NO

YES

S128 — F1=1? — YES

NO

S129 — DOES UPSTREAM SIDE SUBSTRATE SENSOR DETECT DOWNSTREAM SIDE END OF CIRCUIT SUBSTRATE? — NO

YES

F1=1 — S130          C2←C2+1 — S132

C2≧CF? — S131 — NO

YES

OUTPUT ONE PULSE — S133

T←T+△T — S134

S135 — DOES T ELAPSE? — NO

YES

C2←C2+1 — S136

C2≧CF+CD? — S137 — NO

YES

C1, C2, F1=0, SET T TO INITIAL VALUE — S138

END

# FIG.18

[FIRST OPERATION CONTROL WITH CORRECTION]

(a) UPSTREAM SIDE SUBSTRATE SENSOR DETECTS UPSTREAM SIDE END OF CIRCUIT SUBSTRATE

CONVEYANCE DIRECTION ⟶

UPSTREAM SIDE SUBSTRATE SENSOR 60    DOWNSTREAM SIDE SUBSTRATE SENSOR 64

CIRCUIT SUBSTRATE

SET OPERATION AMOUNT

INTER SENSOR DISTANCE    LOGICAL OPERATION AMOUNT

ACTUAL OPERATION AMOUNT

(b) NUMBER OF DRIVE PULSES STARTS TO BE COUNTED

CIRCUIT SUBSTRATE

(c) SET OPERATION AMOUNT, OPERATION, STOP

CIRCUIT SUBSTRATE

ΔL
STOP POSITION ERROR

(d) STOP POSITION ERROR CORRECTION

CIRCUIT SUBSTRATE

EP 2 819 497 B1

## FIG.19

**FIRST OPERATION CONTROL WITH CORRECTION**

- OUTPUT ONE PULSE — S141
- S142 DOES T ELAPSE? — NO / YES
- S145 T←T−△T
- C1←C1+1 — S143
- C1≧CA? — S144 — NO / YES
- OUTPUT ONE PULSE — S146
- S147 DOES T ELAPSE? — NO / YES
- S148 F1=1? — YES / NO
- S149 DOES UPSTREAM SIDE SUBSTRATE SENSOR DETECT DOWNSTREAM SIDE END OF CIRCUIT SUBSTRATE? — NO / YES
- F1=1 — S150
- S154 F2=1? — YES / NO
- C2←C2+1 — S155
- C2←C2+1, C3←C3+1 — S156
- S151 DOES DOWNSTREAM SIDE SUBSTRATE SENSOR DETECT DOWNSTREAM SIDE END OF CIRCUIT SUBSTRATE? — NO / YES
- F2=1 — S152
- C2≧CF? — S153 — NO / YES
- OUTPUT ONE PULSE — S157
- T←T+△T — S158
- S159 DOES T ELAPSE? — NO / YES
- C2←C2+1, C3←C3+1 — S160
- C2≧CF+CD? — S161 — NO / YES
- CALCULATE STOP POSITION ERROR OF CIRCUIT SUBSTRATE, C1, C2, C3, F1, F2=0, SET T TO INITIAL VALUE — S162
- STOP POSITION ERROR CORRECTION OF CIRCUIT SUBSTRATE — S163
- END

**EP 2 819 497 B1**

**REFERENCES CITED IN THE DESCRIPTION**

**Patent documents cited in the description**

- JP 2004228326 A
- JP 8316697 A
- US 2005080508 A1
- US 6354430 B1
- US 2007277369 A1
- JP 2004104075 A